(19) Europäisches Patentamt
European Patent Office
Office européen des brevets

(11) **EP 4 503 141 A1**

(12) **EUROPEAN PATENT APPLICATION**
published in accordance with Art. 153(4) EPC

(43) Date of publication:
**05.02.2025 Bulletin 2025/06**

(21) Application number: 23780292.1

(22) Date of filing: **27.03.2023**

(51) International Patent Classification (IPC):
*H01L 31/0224* (2006.01)   *H01B 1/22* (2006.01)
*H01L 31/068* (2012.01)   *H01L 31/18* (2006.01)

(52) Cooperative Patent Classification (CPC):
**H01B 1/22; H01L 31/0224; H01L 31/068;
H01L 31/18**

(86) International application number:
**PCT/JP2023/012085**

(87) International publication number:
**WO 2023/190282 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.03.2022 JP 2022051760
07.11.2022 JP 2022178203**

(71) Applicant: **Namics Corporation
Niigata-shi, Niigata 950-3131 (JP)**

(72) Inventors:
• **KONNO, Seiya
Niigata-shi, Niigata 950-3131 (JP)**
• **TANABE, Hideo
Niigata-shi, Niigata 950-3131 (JP)**
• **SAITO, Genki
Niigata-shi, Niigata 950-3131 (JP)**

(74) Representative: **Hoffmann Eitle
Patent- und Rechtsanwälte PartmbB
Arabellastraße 30
81925 München (DE)**

(54) **ELECTRICALLY CONDUCTIVE PASTE, SOLAR CELL, AND METHOD FOR MANUFACTURING SOLAR CELL**

(57)    To provide a conductive paste suitable for forming an electrode by a laser treatment process for producing crystalline silicon solar cells. A conductive paste for forming an electrode of a solar cell, comprising conductive particles (A), an organic vehicle (B), and a glass frit (C), wherein a product $B_{GF} \cdot G$ of a basicity $B_{GF}$ of the glass frit (C) and a content G of the glass frit (C) is in a range of 0.25 to 1.45, and the content G of the glass frit (C) is in an unit of part by weight in the conductive paste when a content of the conductive particles (A) in the conductive paste is 100 parts by weight.

EP 4 503 141 A1

**Description**

FIELD OF THE INVENTION

The present invention relates to a conductive paste used for forming an electrode of a semiconductor device or the like. Particularly, the present invention relates to a conductive paste for forming an electrode of a solar cell. The present invention also relates to a solar cell manufactured using the conductive paste for forming the electrode and a method for producing the solar cell.

BACKGROUND ART

In a semiconductor device such as a crystalline silicon solar cell using a crystalline silicon as a substrate that is obtained by processing a single crystalline silicon or a polycrystalline silicon into a flat plate, an electrode is typically formed on the surface of the silicon substrate using a conductive paste for forming the electrode for electrical contact with outside of the device. Among semiconductor devices in which the electrodes are formed in such a way, the production of crystalline silicon solar cells has greatly increased in recent years. These solar cells have an impurity diffusion layer, an antireflection film, and a light incident side surface-electrode on one surface of a crystalline silicon substrate, and a back side electrode on the other surface. By means of the light incident side surface-electrode and the back side electrode, the electric power generated by the crystalline silicon solar cell can be extracted to outside.

A conductive paste containing conductive powder, a glass frit, an organic binder, a solvent, and other additives is used for forming an electrode of a conventional crystalline silicon solar cell. Silver particles (silver powder) are mainly used as the conductive powder.

Patent Document 1 describes a method for improving ohmic contact behavior between a contact grid and an emitter layer of a silicon solar cell. Specifically, the method described in Patent Document 1 describes the following. Specifically, a silicon solar cell (1) is first provided with the emitter layer, the contact grid (5) and a rear contact (3). The contact grid (5) is electrically connected to one pole of a voltage source. A contacting device that is electrically connected to the other pole of the voltage source is connected to the rear contact (3). A voltage directed opposite to the forward direction of the silicon solar cell (1) is applied by the voltage source that is lower than the breakdown voltage. A point light source (13) is guided over the sun-facing side of the silicon solar cell (1) while this voltage is applied. A subsection of the sun-facing side is point illuminated, inducing a current to flow in the partial area. This current acts on the subsection for 1 ms to 100 ms. The current is of a magnitude corresponding to 10-to-30 times the short-circuit current magnitude of the silicon solar cell (1) reduced by the ratio of the area of the subsection to the area of the silicon solar cell (1) measured under standard test conditions.

Patent Document 2 describes a process for improving the ohmic-contact behaviour between a contact grid and an emitter layer in a silicon solar cell. Specifically, the process of Patent Document 2 describes a predetermined voltage is applied directed contrary to the forward direction of the silicon solar cell, a point light source is guided over the sun-facing side of the silicon solar cell and thereby a section of a subsection of the sun-facing side is illuminated.

Patent Document 3 discloses a method for producing a crystalline silicon solar cell using a conductive paste for forming an electrode of a crystalline silicon solar cell containing an inorganic material. Patent Document 3 describes a conductive paste containing conductive particles and glass frit as the inorganic material. Patent Document 3 describes that the glass frit contained in the conductive paste contains 70 to 90 weight % of PbO in 100 weight % of the glass frit and does not contain $Al_2O_3$.

Patent Document 4 describes a conductive composition containing silver powder, glass powder containing PbO, and a vehicle consisting of an organic substance. Patent Document 4 describes that the conductive composition is a conductive composition for forming an electrode which penetrates a silicon nitride layer and is conductive to an n-type semiconductor layer formed under the silicon nitride layer. Patent Document 4 describes that a basicity of the glass powder contained in the conductive composition is 0.6 to 0.8, and a transition point of the glass is 300 degree C to 450 degree C.

Prior Art Documents

Patent Documents

Patent document 1: JP 2019-525471 A
Patent document 2: JP 2021-513218 A
Patent document 3: JP 2011-86754 A
Patent document 4: JP 2009-231826 A

DISCLOSURE OF THE INVENTION

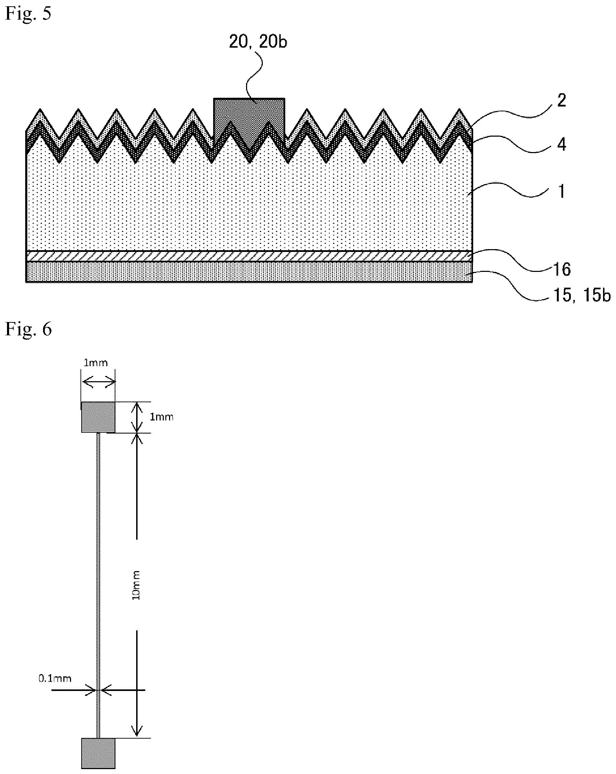

Fig. 5 shows an example of a cross-sectional schematic diagram of a typical crystalline silicon solar cell. As shown in Fig. 5, in the crystalline silicon solar cell, an impurity diffusion layer 4 (for example, a p-type impurity diffusion layer diffused with p-type impurities) is generally formed on the light incident side surface of a crystalline silicon substrate 1 (for example, an n-type crystalline silicon substrate 1). An antireflection film 2 is formed on the impurity diffusion layer 4. Since the antireflection film 2 also functions as a passivation film, the antireflection film 2 is sometimes referred to as a passivation film 2. Further, an electrode pattern of a light incident side surface-electrode 20 (a front surface electrode) is printed on the antireflection film 2 using conductive paste by a screen printing method or the like, the conductive paste is dried, and then fired at a predetermined temperature to form the light incident side surface-electrode 20. In a typical crystalline silicon solar cell, during firing at this predetermined temperature, the conductive paste fires through the antireflection film 2. By this firing through, the light incident side surface-electrode 20 can be formed in contact with the impurity diffusion layer 4. The firing through means that the antireflection film 2, which is an insulating film, is etched with a glass frit or the like included in the conductive paste to form electrical continuity between the light incident side electrodes 20 and the impurity diffusion layer 4. In an example shown in Fig. 5, when an electrode pattern fires through the antireflection film 2 during firing, the antireflection film 2 disappears, and the light incident side surface-electrode 20 and the impurity diffusion layer 4 come into contact with each other. A p-n junction is formed at the interface between the n-type crystalline silicon substrate 1 and the impurity diffusion layer 4. The majority of incident light that has entered the crystalline silicon solar cell enters the p-type crystalline silicon substrate 1 after having penetrated the antireflective film 2 and the impurity diffusion layer 4. In this process, light is absorbed in the n-type crystalline silicon substrate 1, and electron-hole pairs are generated. These electron-hole pairs are such that electrons are separated from the n-type crystalline silicon substrate 1 to the back side electrode 15, and holes are separated from the p-type impurity diffusion layer 4 to the light incident side surface-electrode 20 by the electric field due to the p-n junction. Electrons and holes (carriers) are taken out as electric current through these electrodes.

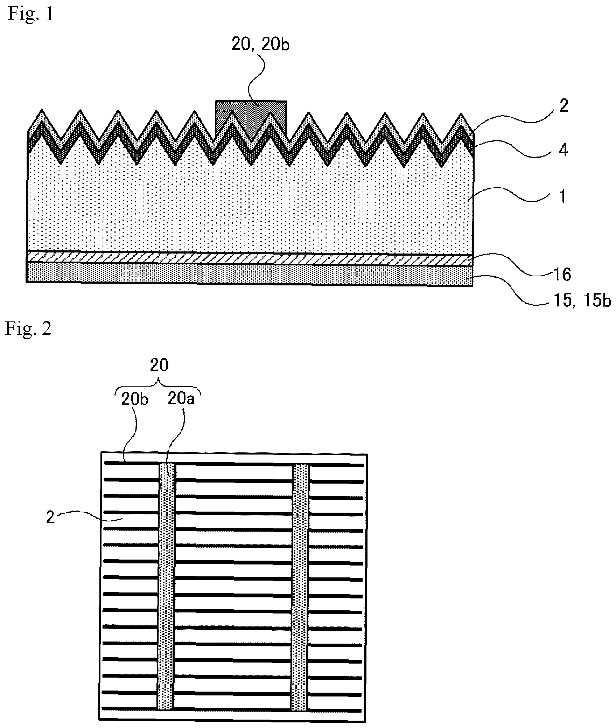

Fig. 2 shows an example of a schematic diagram of a light incident side surface of a crystalline silicon solar cell. As shown in Fig. 2, a bus bar electrode (a light incident side bus bar electrode 20a) and a light incident side finger electrode 20b (it may simply be referred to as "a finger electrode 20b".) are arranged as a light incident side surface-electrode 20 on the light incident side surface of the crystalline silicon solar cell. In the examples shown in Fig. 5 and Fig. 2, electrons among electron-hole pairs generated by incident light entering the crystalline silicon solar cell are collected by the finger electrode 20b and then collected by the light incident side bus bar electrode 20a. A metal ribbon for interconnection covered with solder is soldered to the light incident side bus bar electrode 20a, and the electric current is taken out by the metal ribbon.

In order to obtain a crystalline solar cell with high conversion efficiency, a low contact resistance between the light incident side surface-electrode 20 and the impurity diffusion layer 4 is required.

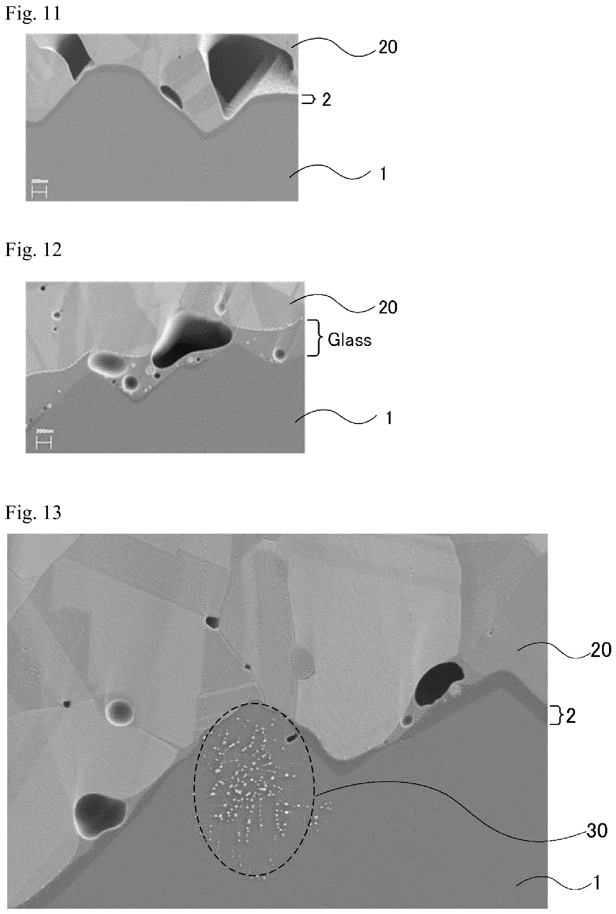

In order to obtain a low contact resistance between the light incident side surface-electrode 20 and the impurity diffusion layer 4, a solar cell manufacturing method using a laser treatment process has been proposed. Patent Documents 1 and 2 describe specific examples of the laser treatment processes. In this specification, the laser treatment process means a technology to obtain low contact resistance, after forming the light incident side surface-electrode 20, by applying a predetermined voltage so that an electric current flows in a direction opposite to the forward direction of a crystalline silicon solar cell, and irradiating the light incident side surface of the solar cell with light from a point light source. In general, by performing the laser treatment process, a fill factor (FF) can be improved without lowering an open circuit voltage (Voc), which is a characteristic of solar cell characteristics. In the laser treatment process, when an electrode pattern of a conductive paste is fired at a predetermined temperature, it is preferable that the conductive paste does not fire through an antireflection film 2 in most of the antireflection film 2 in contact with the electrode pattern. Fig. 1 shows an example of a cross-sectional schematic diagram showing a structure in which the light incident side surface-electrode 20 is formed on the light incident side surface of a crystalline silicon solar cell by using the laser treatment process. As shown in Fig. 1, when the laser treatment process is used, the antireflection film 2 exists in majority portion between the light incident side surface-electrode 20 and the impurity diffusion layer 4. In the laser treatment process, the predetermined voltage described above is applied so that an electric current flows in a direction opposite to the forward direction of the p-n junction, and light from a point light source is irradiated to generate carriers (electrons and holes), whereby an electric current flows in a small area between the light incident side surface-electrode 20 and the impurity diffusion layer 4 and it is locally heated. By the local heating, a small portion where the impurity diffusion layer 4 does not exist locally is formed between the light incident side surface-electrode 20 and the impurity diffusion layer 4. As a result, as shown in Fig. 13, it is considered that AgSi alloy 30 (an alloy of silver and silicon), which is a small electrically conductive portion (a local conductive portion), is locally formed in the impurity diffusion layer 4 in contact with the light incident side surface-electrode 20. Since the AgSi alloy 30 is locally formed in a limited portion, illustration is omitted in Fig. 1. It is considered that this locally formed small electrically conductive portion enables good electrical conduction between the light incident side surface-electrode 20 and the impurity diffusion layer 4. In addition, the antireflection film 2 (passivation film) exists in majority portion between the light incident side surface-electrode 20 and the impurity diffusion layer 4 other than the portion where the local conductive portion is formed. As a result, the fill factor (FF) can be improved as the performance of the solar cell without lowering the open circuit voltage (Voc). Therefore, the conductive paste used for forming the light incident side surface-electrode 20 by the laser treatment process needs to have properties different from those of a conventional conductive paste (a conductive paste that can fire through the antireflection film 2).

In the case of the conventional crystalline silicon solar cell, when the light incident side surface-electrode 20 is formed, the electrode pattern of the conductive paste is fired and the antireflection film 2 is fired through, thereby the electrode pattern contacts the impurity diffusion layer 4. During this firing through, there is a problem that damage is caused to the impurity diffusion layer 4 and the performance of the crystalline silicon solar cell is degraded. On the other hand, in the laser treatment process, the antireflection film 2 is basically not fired through when the light incident side surface-electrode 20 is formed. Therefore, by using the laser treatment process, damage to the impurity diffusion layer 4 can be suppressed.

Therefore, it is an object of the present invention to provide a conductive paste suitable for forming an electrode by the laser treatment process for producing crystalline silicon solar cells.

It is also an object of the present invention to provide a method for producing a crystalline silicon solar cell with high performance using a conductive paste suitable for forming an electrode by the laser treatment process. It is also an object of the present invention to provide a crystalline silicon solar cell with high performance produced by a production method including forming an electrode by the laser treatment process.

In order to solve the above problem, the present invention has following configurations.

(Configuration 1)

Configuration 1 is a conductive paste for forming an electrode of a solar cell, comprising:

conductive particles (A);
an organic vehicle (B); and
a glass frit (C),
wherein a product $B_{GF} \cdot G$ of a basicity $B_{GF}$ of the glass frit (C) and a content G of the glass frit (C) is in a range of 0.25 to 1.45, and the content G of the glass frit (C) is in an unit of part by weight in the conductive paste when a content of the conductive particles (A) in the conductive paste is 100 parts by weight.

(Configuration 2)

Configuration 2 is the conductive paste of Configuration 1, wherein the conductive particles (A) comprise silver particles.

(Configuration 3)

Configuration 3 is the conductive paste of Configuration 1 or 2, wherein the organic vehicle (B) comprises at least one selected from an ethyl cellulose, a rosin ester, an acryl and an organic solvent.

(Configuration 4)

Configuration 4 is the conductive paste of any of Configurations 1 to 3, wherein a product $C_{PbO} \cdot G$ of a content $C_{PbO}$ of PbO and the content G of the glass frit (C) is in a range of 20 to 139, and the content $C_{PbO}$ is in an unit of mol% in the glass frit (C).

(Configuration 5)

Configuration 5 is the conductive paste of any of Configurations 1 to 4, wherein the content G of the glass frit (C) is 0.3 to 4.0 parts by weight.

(Configuration 6)

Configuration 6 is the conductive paste of any of Configurations 1 to 4, wherein the content G of the glass frit (C) is 0.5 to 1.5 parts by weight.

(Configuration 7)

Configuration 7 is the conductive paste of any of Configurations 1 to 6, wherein the glass transition temperature of the glass frit (C) is 300 to 600 degree C.

(Configuration 8)

Configuration 8 is the conductive paste of any of Configurations 1 to 7, wherein the glass frit (C) comprises at least one selected from ZnO, $V_2O_5$, $WO_3$ and $Nb_2O_3$.

(Configuration 9)

Configuration 9 is the conductive paste of any of Configurations 1 to 8, wherein the conductive paste further comprises aluminum particles (D).

(Configuration 10)

Configuration 10 is the conductive paste of Configuration 9, wherein a content of the aluminum particles (D) in the conductive paste is 0.1 to 2.0 parts by weight, when the content of the conductive particles (A) in the conductive paste is 100 parts by weight.

(Configuration 11)

Configuration 11 is the conductive paste of any one of Configurations 1 to 10 for forming an electrode of a solar cell,
wherein the solar cell comprises:

a semiconductor substrate of a first conductivity type;
a semiconductor layer of a second conductivity type disposed on one surface of the semiconductor substrate of the first conductivity type;
a back side electrode disposed so as to be electrically connected to the other surface of the semiconductor substrate of the first conductivity type;
a passivation film disposed in contact with the surface of the semiconductor layer of the second conductivity type; and
a light incident side surface-electrode disposed on at least a portion of the surface of the passivation film,
wherein the light incident side surface-electrode is a light incident side surface-electrode that is processed to irradiate light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction, and
the conductive paste is a conductive paste for forming the light incident side surface.

(Configuration 12)

Configuration 12 is a solar cell comprising:

a semiconductor substrate of a first conductivity type;
a semiconductor layer of a second conductivity type disposed on one surface of the semiconductor substrate of the first conductivity type;
a back side electrode disposed so as to be electrically connected to the other surface of the semiconductor substrate of the first conductivity type;
a passivation film disposed in contact with the surface of the semiconductor layer of the second conductivity type; and
a light incident side surface-electrode disposed on at least a portion of the surface of the passivation film,
wherein the light incident side surface-electrode is a light incident side surface-electrode that is processed to irradiate light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction, and
the light incident side surface-electrode is a fired body of the conductive paste of any of Configurations 1 to 10.

(Configuration 13)

Configuration 13 is a solar cell comprising:

a crystalline silicon substrate of a first conductivity type;
a silicon emitter layer of a second conductivity type disposed on one surface of the semiconductor substrate of the first conductivity type;
a back side electrode disposed so as to be electrically connected to the other surface of the crystalline silicon substrate of the first conductivity type;
a passivation film disposed in contact with the surface of the silicon emitter layer of the second conductivity type; and
a light incident side surface-electrode comprising silver disposed on at least a portion of the surface of the passivation film,
wherein the silicon emitter layer of the second conductivity type has a local conductive portion in direct contact with the light incident side surface-electrode without a passivation film,
the local conductive portion comprises an alloy of silver and silicon, and
the light incident side surface-electrode is a fired body of the conductive paste of any of Configurations 1 to 10.

(Configuration 14)

Configuration 14 is a method for producing a solar cell, comprising:

providing a semiconductor substrate of a first conductivity type;
forming a semiconductor layer of a second conductivity type on one surface of the semiconductor substrate of the first conductivity type;
forming a back side electrode so as to be electrically connected to the other surface of the semiconductor substrate of the first conductivity type;
forming a passivation film so as to be in contact with the surface of the semiconductor layer of the second conductivity type;
forming a light incident side surface-electrode on at least a portion of the surface of the passivation film; and
irradiating light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction,
wherein the light incident side surface-electrode is a fired body of the conductive paste of any of Configurations 1 to 10.

(Configuration 15)

Configuration 15 is use of the conductive paste according to any one of claim 1 to 11 for forming an electrode of a solar cell.

According to the present invention, a conductive paste suitable for forming an electrode by the laser treatment process can be provided for producing crystalline silicon solar cells.

According to the present invention, it is possible to provide a method for producing a crystalline silicon solar cell having high performance by using a conductive paste suitable for forming an electrode by the laser treatment process. According to the present invention, it is possible to provide a crystalline silicon solar cell having high performance produced by a manufacturing method including forming an electrode by the laser treatment process.

BRIEF DESCRIPTION OF THE DRAWINGS

Fig. 1 is an example of a cross-sectional schematic diagram showing a structure in which a light incident side surface-electrode is formed on the light incident side surface of a crystalline silicon solar cell by a laser treatment process using the conductive paste of the present embodiment.
Fig. 2 is an example of a schematic diagram of a light incident side surface of a crystalline silicon solar cell.
Fig. 3 is an example of a schematic diagram of a back surface of a crystalline silicon solar cell.
Fig. 4 is an example of a cross-sectional schematic diagram of a bifacial crystalline silicon solar cell using the conductive paste of the present embodiment.
Fig. 5 is an example of a cross-sectional schematic diagram of a typical crystalline silicon solar cell in the vicinity where a light incident side surface-electrode (finger electrode) exists, and is a cross-sectional schematic diagram showing a state where an antireflection film (passivation film) between an electrode and an impurity diffusion layer disappears due to firing through.

Fig. 6 is a plan schematic diagram showing a pattern for measurement of specific resistance for an electrode formed using a conductive paste.

Fig. 7 is a plan schematic diagram showing a pattern for contact resistance measurement for an electrode formed using a conductive paste.

Fig. 8 is a plan schematic diagram showing a pattern for photoluminescence imaging (PL) measurement for an electrode formed using a conductive paste.

Fig. 9 is an image of photoluminescence emission intensity measured by photoluminescence imaging (PL) for a sample of Example 4.

Fig. 10 is an image of photoluminescence emission intensity measured by photoluminescence imaging (PL) for Comparative Example 1.

Fig. 11 is a cross-sectional SEM photograph (magnification: 20,000 times) of a sample in the vicinity of the passivation film of a light incident side surface, in which light incident side surface-electrode 20 is formed using the same conductive paste as the sample shown in Fig. 9.

Fig. 12 is a cross-sectional SEM photograph (magnification: 20,000 times) of a sample in which light incident side surface-electrode 20 is formed using the same conductive paste as the sample shown in Fig. 10, in the vicinity of the passivation film of light incident side surface.

Fig. 13 is a cross-sectional SEM photograph (magnification: 20,000 times) showing that AgSi alloy, which is a small electrically conductive portion (a local conductive portion), is locally formed in a impurity diffusion layer in contact with a light incident side surface-electrode of a sample prepared under the same conditions as in Example 5.

MODE FOR CARRYING OUT THE INVENTION

Embodiments of the present invention will be specifically described below. The following embodiments are embodiments of the present invention, and the present invention is not limited within the scope thereof.

In the present specification, "crystalline silicon" includes single crystalline and polycrystalline silicon. "Crystalline silicon substrate" refers to a material obtained by forming crystalline silicon into a shape suitable for element formation such as a flat plate for forming a semiconductor device such as an electric element or an electronic element. Any method may be used as the method for producing crystalline silicon. For example, the Czochralski method may be used for single crystalline silicon and the casting method may be used for polycrystalline silicon. Other methods, such as a polycrystalline silicon produced by a ribbon pulling method or a polycrystalline silicon formed on a substrate of a different material such as glass, may be used as the polycrystalline silicon substrate. The term "a crystalline silicon solar cell" refers to a solar cell produced by using a crystalline silicon substrate.

In the present specification, the term "a glass frit" refers to a material mainly composed of a plurality of kinds of oxides, for example, metal oxides, and is generally used in the form of glass-like particles.

The present embodiment is a conductive paste for forming an electrode of a solar cell. The conductive paste of the present embodiment includes conductive particles (A), an organic vehicle (B), and a glass frit (C). The conductive paste of the present embodiment is characterized in that a basicity of the glass frit (C) and the content of the glass frit (C) in the conductive paste are appropriately controlled.

The light-electric conversion efficiency (sometimes it is simply called "conversion efficiency".) of a solar cell is expressed by a product of a fill factor (FF), an open circuit voltage (Voc), and a short circuit current (Jsc). Basically, FF and Voc are in a trade-off relationship, and it is difficult to simultaneously increase both FF and Voc. For example, Patent Documents 1 and 2 describe that the ohmic contact behavior between a grid-shaped electrode that is a light incident side surface-electrode and an impurity diffusion layer (emitter layer) can be improved and the contact resistance between the light incident side surface-electrode and the impurity diffusion layer can be greatly reduced by employing a laser treatment process in the manufacturing of crystalline silicon solar cells. Therefore, by performing the laser treatment process, FF can be improved without lowering Voc.

The inventors of the present invention have found that when a conventional conductive paste (for example, the conductive paste described in Patent Document 3) is applied to a solar cell on which a light incident side surface-electrode is formed in a laser treatment process, the antireflection film and the impurity diffusion layer (and the substrate) are adversely affected, and the conversion efficiency of the solar cell is lowered. The inventors of the present invention have also found that this is caused by the fact that the fire-through properties of the conventional conductive paste to the antireflection film are too strong. Furthermore, the inventors of the present invention have found that the reactivity of the glass frit to the antireflection film can be made appropriate by setting the basicity and the content of the glass frit in an appropriate range. Having obtained the above knowledge, the inventors of the present invention have found a conductive paste preferably used in the production of crystalline silicon using a laser treatment process, thereby leading to completion of the present invention.

By forming an electrode of the crystalline silicon solar cell using the conductive paste of the present embodiment and performing the laser treatment process, a low contact resistance can be obtained between the electrode and the impurity diffusion layer of the solar cell without impairing the function of the antireflection film as the passivation film. Therefore, by performing the laser treatment process using the conductive paste of the present embodiment, a crystalline silicon solar cell having a high conversion efficiency can be obtained. The conductive paste of the present embodiment can be preferably used in a production of the crystalline silicon solar cell to form a light incident side surface-electrode by the laser treatment process.

In the laser treatment process using the conductive paste of the present embodiment, when forming the light incident side surface-electrode 20, the antireflection film 2 (the passivation film) is basically not fired through. Even if the laser treatment process is performed on the light incident side surface-electrode 20, most of the antireflection film 2 (the passivation film) in contact with the light incident side surface-electrode 20 does not disappear. That is, the antireflection film 2 (the passivation film) exists in a large portion (for example, 90% or more of an area of the interface, preferably 95% or more of the area, and more preferably 99% or more of the area) between the light incident side surface-electrode 20 and the impurity diffusion layer 4, other than the portion where a small electrical conductive portion (a local conductive portion) is locally formed. Therefore, damage to the impurity diffusion layer 4 can be suppressed by using the laser treatment process when the light incident side surface-electrode 20 is formed.

As shown in Fig. 1, a finger electrode 20b is arranged as a light incident side surface-electrode 20 on a light incident side surface of a crystalline silicon solar cell. In the example shown in Fig. 1, holes among electron-hole pairs generated by incident light entering the crystalline silicon solar cell are collected into the finger electrode 20b via the impurity diffusion layer 4 (for example, a p-type impurity diffusion layer 4). Therefore, the contact resistance between the finger electrode 20b and the impurity diffusion layer 4 is required to be low. The conductive paste of the present embodiment can be preferably used for forming the finger electrode 20b.

In the present specification, a light incident side surface-electrode 20 and a back side electrode 15, which are electrodes for extracting electric current from the crystalline silicon solar cell to the outside, may be collectively referred to simply as "an electrode".

One type of crystalline silicon solar cell is a bifacial crystalline silicon solar cell in which light is incident from two surfaces (first and second light incident side surfaces) to generate electricity. In this case, electrodes formed on the first and second light incident side surfaces, by using the conductive paste of the present embodiment, can preferably be used.

The conductive paste of the present embodiment can preferably be used to form the light incident side surface-electrode 20 formed on the light incident side surface of the antireflection film 2 (passivation film) formed on the impurity diffusion layer, but is not limited thereto. For example, a back side electrode 15 may be formed on a surface (a back surface) opposite to the light incident side surface by using the conductive paste of the present embodiment. A passivation film may be formed on the back surface of the crystalline silicon solar cell, and the back side electrode 15 may be formed on the passivation film. In the case of the solar cell having such a structure, the conductive paste of the present embodiment can be used to form an electrical contact between the back side electrode 15 and the crystalline silicon substrate 1 of the solar cell through the passivation film on the back surface.

Hereinafter, the conductive paste of the present invention will be described, by taking as an example, a case of forming the light incident side electrode 20 (a front surface electrode) of the crystalline silicon solar cell using the n-type crystalline silicon substrate 1. In the case of the crystalline silicon solar cell, the impurity diffusion layer 4 formed on the light incident side surface is a p-type impurity diffusion layer 4. In the present specification, the impurity diffusion layer 4 in the case of the solar cell using the crystalline silicon substrate 1 is sometimes referred to as a "silicon emitter layer". An antireflection film 2 is formed on the surface of the p-type impurity diffusion layer 4.

The passivation film (the antireflection film 2) may be a film consisting of a single layer or a plurality of layers. When the passivation film is a single layer, a thin film (SiN film) using silicon nitride (SiN) as a material is preferable from the viewpoint that the passivation of the surface of the silicon substrate can be effectively performed. When the passivation film is a plurality of layers, a laminated film ($SiN/SiO_x$ film) of a thin film of silicon nitride as a material and a thin film of silicon oxide as a material is preferable. When the $SiN/SiO_x$ film is a passivation film, the $SiN/SiO_x$ film is preferably formed so that the $SiO_x$ film is in contact with the silicon substrate 1 from the viewpoint that the passivation of the surface of the silicon substrate can be more effectively performed. The $SiO_x$ film may be a natural oxide film of the silicon substrate.

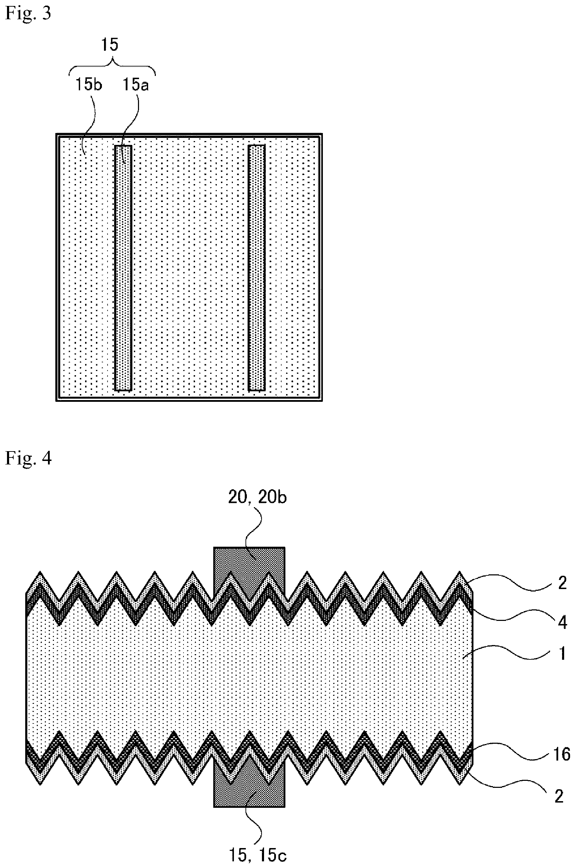

The crystalline silicon solar cell may have a light incident side bus bar electrode 20a and/or a back side TAB electrode 15a. The light incident side bus bar electrode 20a has a function of electrically connecting the finger electrode 20b for collecting the electric current generated by the solar cell and the metal ribbon for the interconnection. Similarly, the back side TAB electrode 15a has a function of electrically connecting the back side full-surface electrode 15b for collecting the electric current generated by the solar cell and the metal ribbon for the interconnection. When the finger electrode 20b comes into contact with the crystalline silicon substrate 1, a density of surface defects of the surface (interface) of the crystalline silicon substrate 1 at the portion where the finger electrode 20b comes into contact with increases, and the solar cell performance decreases. The conductive paste of the present invention, especially as a conductive paste for the finger electrode 20b, does not completely fire through the antireflection film 2 because of its low fire-through properties (reactivity) to the antireflection film 2. Therefore, when the finger electrode 20b is formed by using the conductive paste of the present invention, the passivation film in the portion in contact with the crystalline silicon substrate 1 can be kept as it is, and the increase in the density of surface defects which causes the recombination of carriers can be prevented. Therefore, the conductive paste of the present embodiment described above can be suitably used as a conductive paste for forming the finger electrode 20b of the crystalline silicon solar cell. It should be noted that the conductive paste of the present embodiment can also be suitably used as the back side electrode 15 (back side finger electrode 15c) of the bifacial crystalline silicon solar cell as shown in Fig. 4. The entire electrode 20 can be formed by using the conductive paste of the present embodiment.

In the laser treatment process, the conductive paste of the present embodiment is locally heated by applying the predetermined voltage and irradiating light from a point light source, whereby an electric current flows to a small region between the light incident side surface-electrode 20 and the impurity diffusion layer 4 (silicon emitter layer). As a result, as shown in Fig. 13, AgSi alloy 30, which is a local electrically conductive portion (a local conductive portion), is formed in the impurity diffusion layer 4 (the silicon emitter layer) in contact with the light incident side surface-electrode 20. It is considered that this locally formed electrically conductive portion enables good electrical conduction between the light incident side surface-electrode 20 and the impurity diffusion layer 4 (the silicon emitter layer). Therefore, it is necessary that the conductive paste used for forming the light incident side surface-electrode by the laser treatment process has properties different from those of a conventional conductive paste (a conductive paste that can fire through the antireflection film 2).

The conductive paste of the present embodiment will be described in detail.

<Conductive Particles (A)>

The conductive paste of the present embodiment comprises conductive particles (A).

In the conductive paste of the present embodiment, metal particles or alloy particles can be used as the conductive particles. Examples of metals contained in the metal particles or alloy particles include silver, gold, copper, nickel, zinc and tin. Silver particles (Ag particles) can be used as the metal particles. The conductive paste of the present embodiment can include other metals other than silver, such as gold, copper, nickel, zinc and tin. From the viewpoint of obtaining low electric resistance and high reliability, the conductive particles are preferably silver particles consisting of silver. The silver particles consisting of silver can contain other metal elements as unavoidably contained impurities. A large number of silver particles (Ag particles) may be referred to as silver powder (Ag powder). The same applies to other particles.

The particle shape and particle size (also referred to as particle diameter or particle diameter) of conductive particles are not particularly limited. The particle shape may be, for example, spherical or scaly shape. The particle size of the conductive particles may be defined by the particle size (D50) of the integrated value of 50% of all particles. In the present specification, D50 is also referred to as the average particle size. The average particle size (D50) may be determined from the result of measurement of particle size distribution performed by the micro-tracking method (laser diffraction scattering method).

The average particle size (D50) of the conductive particles is preferably 0.5 to 2.5 $\mu$m, more preferably 0.8 to 2.2 $\mu$m. Since the average particle size (D50) of the conductive particles is within the predetermined range, the reactivity of the conductive paste to the passivation film can be suppressed during firing of the conductive paste. When the average particle size (D50) is larger than the above range, problems such as clogging may occur during screen printing.

The size of the silver particles can be expressed as BET specific surface area (also referred to simply as "specific surface area"). The BET specific surface area of the silver particles is preferably 0.1 to 1.5 $m^2$/g, more preferably 0.2 to 1.2 $m^2$/g. The BET specific surface area can be measured using, for example, a fully automatic specific surface area measuring device, Macsoeb (manufactured by MOUNTEC).

<(B) Organic Vehicle>

The conductive paste of the present embodiment includes an organic vehicle (B).

The organic vehicle may include an organic binder and a solvent. The organic binder and the solvent fulfill a role of adjusting a viscosity of the conductive paste, and any of them is not particularly limited. The organic binder may be dissolved in the solvent.

In the conductive paste of the present embodiment, the organic vehicle (B) preferably contains at least one selected from ethyl cellulose, a rosin ester, an acryl and an organic solvent. When the organic vehicle (B) contains at least one selected from an ethyl cellulose, a rosin ester, an acryl and an organic solvent, screen printing of the conductive paste can be suitably performed and the shape of the pattern to be printed can be appropriately shaped.

The organic binder can be selected from cellulosic resins (e.g., ethyl cellulose, nitrocellulose, etc.) and (meth) acrylic resins (for example, polymethyl acrylate or polymethyl methacrylate, etc.). The organic vehicle contained in the conductive paste of the present embodiment preferably contains at least one selected from an ethyl cellulose, a rosin ester, a butyral, an acryl and an organic solvent. The amount of the organic binder to be added is usually 0.1 to 30 parts by weight and preferably 0.2 to 5 parts by weight based on 100 parts by weight of silver particles.

As the organic solvent, one type or two or more types selected from alcohols (for example, terpineol, α-terpineol or β-terpineol, and the like) and esters (for example, hydroxyl group-containing esters, 2,2,4-trimethyl-1,3-pentanediol monoisobutyrate, diethylene glycol monobutyl ether acetate (butyl carbitol acetate), and the like) can be used. The amount of the solvent to be added is usually 0.5 to 30 parts by weight and preferably 2 to 25 parts by weight based on 100 parts by weight of silver particles. Specific example of the organic solvent include diethylene glycol monobutyl ether acetate (butyl carbitol acetate).

<Glass frit (C)>

The conductive paste of the present embodiment includes glass frit (C).

In the conductive paste of the present embodiment, a product $B_{GF} \cdot G$ of a basicity $B_{GF}$ of the glass frit (C) and a content G of the glass frit (C) is in a range of 0.25 to 1.45, preferably in the range of 0.3 to 1.4, and more preferably in the range of 0.4 to 1.2, and the content G of the glass frit (C) is in an unit of part by weight in the conductive paste when a content of the conductive particles (A) in the conductive paste is 100 parts by weight. By setting the product $B_{GF} \cdot G$ of the basicity $B_{GF}$ and the content G of the glass frit to an appropriate range, the reactivity of the glass frit to the antireflection film 2 (the passivation film) can be made appropriate. Therefore, the conductive paste of the present embodiment can be preferably used in the production of crystalline silicon using the laser treatment process.

The basicity of the glass frit can be calculated by the method described in Patent document 4 (JP 2009-231826 A). That is, the "basicity" can be specified as the basicity of the glass powder using the formula shown in "K. Morinaga, H. Yoshida and H. Takebe: J. AmCerm. Soc., 77, 3113 (1994)". In particular, it is as follows.

The binding force between $M_i$ and O in oxide $M_iO$ is given by the following equation as the attractive force $A_i$ between cation and oxygen ion.

$$A_i = Z_i \cdot Z_{02-} / (r_i + r_{02-})^2 = Z_i \cdot 2 / (r_i + 1.40)^2$$

$Z_i$ : valence of cation, oxygen ion is 2
$r_i$ : ionic radius of cation (angstrom)

The ionic radius $r_i$ of oxygen ion is 1.40 nm. Let the reciprocal $B_i$ (= 1 / $A_i$) of $A_i$ in the above equation be the oxygen donating ability of the single component oxide $M_iO$.

$$B_i \equiv 1 / A_i$$

When $B_i$ is normalized as $B_{CaO} = 1$ and $B_{SiO_2} = 0$, the $B_i$- index of each single component oxide is given. By expanding the $B_i$- index of each component to a multicomponent system by the cation fraction, the basicity (=$B_{GF}$) of a melt of a glass oxide (glass frit) of an arbitrary composition can be calculated.

$$B_{GF} = \Sigma\, n_i \cdot B_i$$

$n_i$ : cation fraction

The basicity ($B_{GF}$) thus defined represents the oxygen donating ability as described above, and the larger the value, the easier the oxygen donating ability and the easier the exchange of oxygen with other metal oxides. In other words, the "basicity" can be said to represent the degree of dissolution in the glass melt.

The content G of the glass frit (C) is a dimensionless number because it is a ratio to the content of the conductive particles (A). Also, as described above, since $B_i$ is normalized to $B_{CaO} = 1$ and $B_{SiO_2} = 0$, the basicity $B_{GF}$ (= $\Sigma n_i \cdot B_i$) of the glass frit (C) is a dimensionless number. Therefore, the product $B_{GF} \cdot G$ of the basicity $B_{GF}$ and the content G of the glass (C) frit is also a dimensionless number.

The basicity ($B_{GF}$) of the glass frit in the present embodiment is preferably 0.30 to less than 0.80, more preferably 0.35 to 0.75, and further more preferably 0.40 to 0.70. When the basicity ($B_{GF}$) is in such a range, the reactivity of the glass frit to the passivation film can be made appropriate by adjusting the amount of the glass frit in the conductive paste.

The content G of the glass frit in the conductive paste in the present embodiment is preferably 0.3 to 4.0 parts by weight, more preferably 0.4 to 3.0 parts by weight, further more preferably 0.5 to 2.0 parts by weight, and particularly preferably 0.5 to 1.5 parts by weight, with respect to the 100 parts by weight of the conductive particles. By appropriately adjusting the content G of the glass frit in the conductive paste together with the basicity ($B_{GF}$), the reactivity of the glass frit to the passivation film can be made appropriate.

The glass frit contained in the conductive paste of the present embodiment preferably contains one or more selected from $PbO$, $SiO_2$, $Al_2O_3$, $B_2O_3$, $ZnO$, $V_2O_5$, $WO_3$ and $Nb_2O_3$. The glass frit contained in the conductive paste of the present embodiment more preferably contains $PbO$, $SiO_2$, $Al_2O_3$, $B_2O_3$ and $ZnO$.

In the conductive paste of the present embodiment, the glass frit (C) preferably contains at least one selected from $ZnO$, $V_2O_5$, $WO_3$ and $Nb_2O_3$. When the glass frit contains at least one of these oxides, the basicity of the glass frit can be adjusted to an appropriate range.

The glass frit preferably contains $PbO$. The content of $PbO$ in the glass frit (100 mol%) is preferably 25 to 60 mol%, more preferably 30 to 55 mol%, and further more preferably 40 to 55 mol%. When the glass frit contains $PbO$, reactivity to the passivation film can be suppressed and contact resistance can be reduced.

The glass frit preferably contains $SiO_2$. The content of $SiO_2$ in the glass frit (100 mol%) is preferably 20 to 65 mol%, more preferably 25 to 60 mol%. When the glass frit contains $SiO_2$, the reactivity to the passivation film can be suppressed.

The glass frit preferably contains $Al_2O_3$. The content of $Al_2O_3$ in the glass frit (100 mol%) is preferably 3.0 to 6.8 mol%, more preferably 3.5 to 6 mol%. When the glass frit contains $Al_2O_3$, the reactivity to the passivation film can be suppressed.

The glass frit preferably contains $B_2O_3$. The content of $B_2O_3$ in the glass frit (100 mol%) is preferably 3.0 to 15 mol%, more preferably 3.5 to 12 mol%.

The glass frit preferably contains $ZnO$. The content of $ZnO$ in the glass frit (100 mol%) is preferably 5 to 20 mol%, more preferably 8 to 15 mol%. Since the glass frit contains $ZnO$, the basicity of the glass frit can be adjusted to an appropriate range.

In the conductive paste of the present embodiment, the product $C_{PbO} \cdot G$ of a content $C_{PbO}$ of $PbO$ in mol% in the glass frit (C) and the content G of the glass frit (C) is preferably in the range of 20 to 139, more preferably in the range of 22 to 130, and further more preferably in the range of 26 to 105. When the product $C_{PbO} \cdot G$ exceeds 139, the reactivity between the glass frit and the passivation film becomes too high. When the product $C_{PbO} \cdot G$ is less than 20, the contact resistance between the obtained electrode and the impurity diffusion layer becomes too high.

The glass transition temperature (Tg) of the glass frit (C) in the conductive paste of the present embodiment is preferably 300 to 600 degree C, more preferably 320 to 500 degree C, and further more preferably 350 to 450 degree C. By setting the glass transition temperature (Tg) of the glass frit (C) to 300 degree C or more, the reactivity to the passivation film can be suppressed. By setting the glass transition temperature (Tg) to 600 degree C or less, contact resistance between the obtained electrode and the impurity diffusion layer can be reduced.

The glass transition temperature (Tg) can be measured as follows. That is, using a thermogravimetric apparatus (TG-DTA2000SA manufactured by McScience Inc., Ltd.), a glass powder to be a sample and a reference material are set in a thermogravimetric apparatus and the temperature is raised from room temperature to 900 degree C at a heating rate of 10 degree C / minute as the measurement condition, and a curve (DTA curve) is obtained in which the temperature difference between the glass powder to be a sample and the reference material is plotted against the temperature. The first inflection point of the DTA curve obtained in this way can be set as the glass transition temperature (Tg).

The shape of the glass frit particles is not particularly limited, and for example, spherical or amorphous particles can be used. The particle size is also not particularly limited. From the viewpoint of workability and the like, the average particle size (D50) of the particles is preferably in the range of 0.1 to 10 $\mu$m, and more preferably in the range of 0.5 to 5 $\mu$m.

As the particles of the glass frit, one kind of particles containing a predetermined amount of each of a plurality of necessary oxides can be used. Particles consisting of a single oxide can also be used as different particles for each of a plurality of necessary oxides. A plurality of kinds of particles having different compositions of a plurality of necessary oxides can also be used in combination.

<Aluminum Particles>

The conductive paste of the present embodiment can further include aluminum particles (D). The aluminum particles (D) can be included as particles separate from the conductive particles (A).

In the crystalline silicon substrate, aluminum has a property of being a p-type impurity. When the conductive paste printed on the crystalline silicon is fired, aluminum in the conductive paste diffuses into the crystalline silicon and becomes a p-type impurity. Therefore, when the electrode is formed on the surface of the p-type impurity diffusion layer of the crystalline silicon substrate, low contact resistance can be obtained between the electrode and the p-type impurity diffusion layer by the conductive paste containing the aluminum particles. Therefore, when the electrode is formed on the surface of the p-type impurity diffusion layer of the crystalline silicon substrate, the conductive paste preferably contains the aluminum particles.

When the conductive paste of the present embodiment contains the aluminum particles (D), the content of aluminum particles (D) in the conductive paste is preferably 0.1 to 2.0 parts by weight and more preferably 0.5 to 2.0 parts by weight when the content of conductive particles (A) in the conductive paste is 100 parts by weight. When the conductive paste contains a predetermined amount of the aluminum particles, low contact resistance can be obtained between the electrode and the p-type impurity diffusion layer.

On the other hand, when the electrode is formed on the surface of the n-type impurity diffusion layer of the crystalline silicon substrate or the n-type crystalline silicon substrate, aluminum in the conductive paste diffuses into the n-type impurity diffusion layer or the like, which adversely affects solar cell characteristics. Therefore, when the electrode is formed on the surface of the n-type impurity diffusion layer of the crystalline silicon substrate or the n-type crystalline silicon substrate, the conductive paste of the present embodiment preferably does not contain the aluminum particles (D) (the content of the aluminum particles (D) is zero).

The aluminum particles mainly contain an element of aluminum. The purity of aluminum in the aluminum particles is preferably 99.7% or more, more preferably 99.9% or more. The aluminum particles may contain impurities other than aluminum, for example, other metal elements inevitably contained therein. The aluminum particles may also contain an alloy of aluminum with other metal elements, an oxide of aluminum, and the like.

The shape of the aluminum particles is exemplified as spherical or ellipsoidal, but is not limited thereto. From the viewpoint of good printability and good reaction with the semiconductor substrate, the shape of the aluminum particles is preferably spherical.

The average particle size (D50) of the aluminum particles is also not particularly limited. When the average particle size (D50) of the aluminum particles is 1 $\mu$m or more and 20 $\mu$m or less, it is preferable because the printability of the paste composition is improved and the reactivity with the semiconductor substrate is also improved. More preferably, the average particle size (D50) of the aluminum particles is 2 to 4 $\mu$m.

<Other Components>

The conductive paste of the present embodiment can contain additives and additive materials other than those described above within a range that does not adversely affect the solar cell characteristics of the obtained solar cell.

In the conductive paste of the present embodiment, additives selected from plasticizers, antifoaming agents, dispersants, leveling agents, stabilizers, adhesion promoters, and the like can be further incorporated as required. Among these, as the plasticizers, at least one selected from phthalic esters, glycolic esters, phosphoric esters, sebatic esters, adipic esters, citric esters, and the like can be used.

The conductive paste of the present embodiment can contain additives other than those described above within a range that does not adversely affect the solar cell characteristics of the obtained solar cell. For example, the conductive paste of the present embodiment may further include at least one additive selected from titanium resinate, titanium oxide, cobalt oxide, cerium oxide, silicon nitride, copper manganese tin, aluminosilicate, and aluminum silicate. The inclusion of these additives may improve the adhesion strength of the electrode to the passivation film. These additives may be in the form of particles (additive particles). The amount of additive added to the silver particles 100 parts by weight is preferably 0.01 to 5 parts by weight, more preferably 0.05 to 2 parts by weight. In order to obtain higher adhesion strength, the additive is preferably copper manganese tin, aluminosilicate or aluminum silicate. The additive may include both aluminosilicate and aluminum silicate.

<Method for Producing Conductive Paste>

Next, a method for producing the conductive paste of the present embodiment will be described. The conductive paste of the present embodiment may be produced by adding, mixing, and dispersing silver particles, glass frit, and, if necessary, other additives and/or additive materials to an organic binder and a solvent.

Mixing can be performed by, for example, a planetary mixer. Dispersion can be performed by a three-roll mill. Mixing and dispersion are not limited to these methods, and various known methods can be used.

<Solar Cell>

Next, a solar cell of the present embodiment will be described. The present embodiment is a solar cell in which at least a part of the electrode is formed by using the conductive paste described above. Figs. 1 and 4 show cross-sectional schematic diagrams of crystalline silicon solar cells.

In the solar cell of the present embodiment, crystalline silicon, silicon carbide, germanium, gallium arsenide, or the like can be used as a material of the semiconductor substrate. From the viewpoint of safety and cost of the solar cell, the material of the semiconductor substrate is preferably crystalline silicon (single crystalline silicon and polycrystalline silicon, etc.).

The solar cell of the present embodiment includes a semiconductor substrate of a first conductivity type, a semiconductor layer of a second conductivity type disposed on one surface of the semiconductor substrate of the first conductivity type, a passivation film (an antireflection film 2) disposed in contact with the surface of the semiconductor layer of the second conductivity type, and a light incident side surface-electrode 20 disposed on at least a portion of the surface of the passivation film. The solar cell of the present embodiment can also include a back side electrode 15 disposed so as to be electrically connected to the other surface of the semiconductor substrate of the first conductivity type. In the example of Fig. 1, the semiconductor substrate of the first conductivity type is a crystalline silicon substrate 1, the semiconductor layer of the second conductivity type is an impurity diffusion layer 4, and the passivation film is an antireflection film 2.

The semiconductor substrate of the first conductivity type is an n-type semiconductor substrate or a p-type semiconductor substrate. The semiconductor layer of the second conductivity type is a p-type semiconductor layer or an n-type semiconductor layer. When the semiconductor substrate is an n-type semiconductor substrate, a p-type semiconductor layer (a p-type impurity diffusion layer 4) is disposed on one surface of the semiconductor substrate. When the semiconductor substrate is a p-type semiconductor substrate, an n-type semiconductor layer (an n-type impurity diffusion layer 4) is disposed on one surface of the semiconductor substrate. The material of the semiconductor substrate is preferably silicon. Therefore, the semiconductor substrate is preferably a crystalline silicon substrate.

The passivation film may be an antireflection film 2. The passivation film is preferably a thin film made of silicon nitride.

The light incident side surface-electrode 20 of the solar cell of the present embodiment may be a fired body of the conductive paste of the present embodiment. The conductive paste of the present embodiment may be used to produce solar cells of this structure.

The conductive paste of the present embodiment can preferably be used to form a light incident side surface-electrode 20 of a crystalline silicon solar cell using a laser treatment process. The laser treatment process refers to a process of irradiating the light incident side surface of the solar cell with light from a point light source while applying a voltage to the back side electrode 15 and the light incident side surface-electrode 20 so that an electric current flows in a direction opposite to the forward direction of the p-n junction between the semiconductor layer of the second conductivity type and the semiconductor substrate of the first conductivity type. The light from the point light source generates carriers (electron-hole pairs) in the semiconductor substrate, and the carriers can move, i.e., an electric current can flow, by applying a voltage. The voltage is applied so that the electric current flows in a direction opposite to the forward direction of the p-n junction. Therefore, when the semiconductor substrate is an n-type semiconductor substrate and the semiconductor layer is a p-type semiconductor layer, a voltage is applied to the back side electrode 15 and the light incident side surface-electrode 20 so that the electric current flows from the n-type semiconductor substrate to the p-type semiconductor layer. Also, when the semiconductor substrate is a p-type semiconductor substrate and the semiconductor layer is an n-type semiconductor layer, a voltage is applied to the back side electrode 15 and the light incident side surface-electrode 20 so that the electric current flows from the n-type semiconductor layer to the p-type semiconductor substrate.

The semiconductor substrate of the first conductivity type of the solar cell of the present embodiment is preferably an n-type semiconductor substrate, and more preferably an n-type crystalline silicon substrate. The semiconductor layer of the second conductivity type of the solar cell of the present embodiment is preferably a p-type semiconductor layer, and more preferably a p-type impurity diffusion layer 4 using crystalline silicon as a material. Generally, the mobility of electrons as carriers in the n-type crystalline silicon substrate is higher than that of holes as carriers in the p-type crystalline silicon substrate. Therefore, in order to obtain a solar cell having high conversion efficiency, it is advantageous to use an n-type crystalline silicon substrate.

In the following description, a solar cell in which the semiconductor substrate of the first conductivity type is an n-type crystalline silicon substrate 1 and the semiconductor layer of the second conductivity type is a p-type impurity diffusion layer 4 (it is sometimes simply referred to as "impurity diffusion layer 4".) is taken as an example.

As shown in Fig. 1, when a laser treatment process is used, an antireflection film 2 (a passivation film) exists in a large portion between the light incident side surface-electrode 20 and the impurity diffusion layer 4. In the laser treatment process, an electric current flows in a small area between the light incident side surface-electrode 20 and the impurity diffusion layer 4 and the small area is locally heated by applying the aforementioned predetermined voltage so that an electric current flows in a direction opposite to the forward direction of the p-n junction and irradiating light (for example, laser light) from a point light source. As a result, as shown in Fig. 13, an AgSi alloy 30 (an alloy of silver and silicon), which is a local electrical conductive portion (a local conductive portion), is formed between the light incident side surface-electrode 20 and the impurity diffusion layer 4. That is, the local conductive portion includes an alloy of silver and silicon. In the local conductive portion, the impurity diffusion layer 4 (a silicon emitter layer of the second conductivity type) is directly in contact with the light incident side surface-electrode without an antireflection film 2 (a passivation film). The locally formed electrically conductive portion (the local conductive portion) enables good electrical conduction between the light incident side surface-electrode 20 and the impurity diffusion layer 4. The conductive paste of the present embodiment is less reactive to antireflection film 2 than conventional conductive pastes and has appropriate reactivity with the antireflection film 2 (the passivation film) for the laser treatment processes. Therefore, the conductive paste of the present embodiment can be preferably used to form the light incident side surface-electrode 20 of the crystalline silicon solar cell using the laser treatment process.

The crystalline silicon solar cell shown in Fig. 1 can have a back side electrode 15 of the structure shown in Fig. 3. The back side electrode 15 is arranged to be electrically connected to the other surface of the semiconductor substrate of the first conductivity type. As shown in Fig. 3, the back side electrode 15 can generally include a back side full-surface electrode 15b and a back side TAB electrode 15a electrically connected to the back side full-surface electrode 15b.

An example of a cross-sectional schematic diagram of a bifacial crystalline silicon solar cell is shown in Fig. 4. The bifacial crystalline silicon solar cell shown in Fig. 4 has an impurity diffusion layer 4, an antireflection film 2 and a back side passivation film 14. In the bifacial crystalline silicon solar cell, by using the conductive paste of the present embodiment to form the light incident side surface-electrode 20 (in particular, the finger electrode 20b) of the light incident side surface and the back side electrode 15 (the back side finger electrode 15c) , a portion with electrically conductive (a local conductive portion) in the passivation film (the antireflection film 2) on the light incident side surface and the back side passivation film 14 can be formed using a laser treatment process.

Therefore, the conductive paste of the present embodiment described above can be suitably used as a conductive paste for forming the finger electrode 20b of the crystalline silicon solar cell. The conductive paste of the present embodiment can also be used as a conductive paste for forming the back side electrode 15 of the bifacial crystalline solar cell.

A bus bar electrode of the crystalline silicon solar cell shown in Fig. 1 includes a light incident side bus bar electrode 20a shown in Fig. 2 and a back side TAB electrode 15a shown in Fig. 3. The light incident side bus bar electrode 20a and the back side TAB electrode 15a are soldered with a metal ribbon covered with solder for interconnection. The electric current generated by the solar cell is taken out of the crystalline silicon solar cell by this metal ribbon. The bifacial crystalline solar cell shown in Fig. 4 can also have a back side TAB electrode of the same shape as the light incident side bus bar electrode 20a.

The width of the bus bar electrode (the light incident side bus bar electrode 20a and back side TAB electrode 15a) can be almost same width as the width of the metal ribbon for interconnection. In order for the bus bar electrode to have a low electric resistance, a wider width is preferable. On the other hand, in order to increase the incident area of light on the light incident side surface, the width of the light incident side bus bar electrode 20a is preferable to be narrower. Therefore, the bus bar electrode width can be 0.05 to 5 mm, preferably 0.08 to 3 mm, more preferably 0.1 to 2 mm, and further more preferably 0.15 to 1 mm. The number of bus bar electrodes can be determined in accordance with the size of the crystalline silicon solar cell. The number of bus bar electrodes is arbitrary. Specifically, the number of bus bar electrodes can be 3, 4, or more. The optimum number of bus bar electrodes can be determined by simulation of solar cell operation so as to maximize the conversion efficiency of the crystalline silicon solar cell. The number of light incident side bus bar electrodes 20a and the number of the back side TAB electrode 15a is preferably the same because the crystalline silicon solar cells are connected in series with each other by a metal ribbon for interconnection. For the same reason, the width of the light incident side bus bar electrodes 20a and the width of the back side TAB electrode 15a is preferably the same.

In order to increase the incident area of light on the crystalline silicon solar cell, the area occupied by the light incident side surface-electrode 20 is preferably as small as possible. For this reason, the finger electrodes 20b on the light incident side surface are preferably as narrow as possible and as few as possible. On the other hand, from the viewpoint of reducing electric loss (ohmic loss), it is preferable that the width of the finger electrodes 20b is wider and the number of the finger electrodes is larger. Also, from the viewpoint of reducing contact resistance between the finger electrodes 20b and the crystalline silicon substrate 1 (the impurity diffusion layer 4), it is preferable that the width of the finger electrodes 20b is wider. From the above, the number of bus bar electrodes can be determined in accordance with the size of the crystalline silicon solar cell and the width of the bus bar electrodes. The optimum width and number of the finger electrodes 20b (spacing of the finger electrodes 20b) can be determined by simulation of solar cell operation so as to maximize the conversion efficiency of the crystalline silicon solar cell. The width and number of the back side finger electrodes 15c of the back side electrode 15 of the bifacial crystalline silicon solar cell shown in Fig. 4 can be determined in the same manner.

<Manufacturing Method of Solar Cell>

Next, a manufacturing method of the solar cell of the present embodiment will be described. The solar cell may be a crystalline silicon solar cell. In the following description, an example in which the solar cell is the crystalline silicon solar cell will be described.

The manufacturing method of the solar cell of the present embodiment includes a step of printing the above described conductive paste on the surface of the antireflection film 2 on the semiconductor layer (the impurity diffusion layer 4) of the second conductivity type, drying, and firing to form an electrode (a light incident side surface-electrode). The manufacturing method of the solar cell of the present embodiment will be described in more detail below.

The manufacturing method of the solar cell of the present embodiment includes a step of preparing a semiconductor substrate (for example, a crystalline silicon substrate 1) of a first conductivity type (p-type or n-type).

As the semiconductor substrate of the first conductivity type, an n-type crystalline silicon substrate 1 is preferably used. Hereinafter, a case of manufacturing a crystalline silicon solar cell using an n-type crystalline silicon substrate 1 will be described as an example.

From the viewpoint of obtaining high conversion efficiency, the surface of the light incident side of the crystalline silicon substrate 1 preferably has a pyramid-like texture structure.

Next, the manufacturing method of the solar cell of the present embodiment includes a step of forming a semiconductor layer of a second conductivity type on one surface of the semiconductor substrate of the first conductivity type.

The manufacturing method of the crystalline silicon solar cell of the present embodiment includes a step of forming a semiconductor layer (an impurity diffusion layer 4) of a second conductivity type on one surface of the crystalline silicon substrate 1 prepared in the above step. When the n-type crystalline silicon substrate 1 is used as the crystalline silicon substrate 1, a p-type impurity diffusion layer 4, in which a p-type impurity of B (boron) and the like is diffused, can be formed as the impurity diffusion layer 4. It is also possible to manufacture the crystalline silicon solar cell using a p-type crystalline silicon substrate. In this case, an n-type impurity diffusion layer 4, in which an n-type impurity of P (phosphorus) and the like is diffused, is formed as the impurity diffusion layer.

When the impurity diffusion layer 4 is formed, a sheet resistance of the impurity diffusion layer 4 can be 40 to 150 $\Omega/\square$ (square), preferably 45 to 120 $\Omega/\square$.

Further, in the method of manufacturing the crystalline silicon solar cell of the present embodiment, a depth at which the impurity diffusion layer 4 is formed may be 0.3 $\mu$m to 1.0 $\mu$m. The depth of the impurity diffusion layer 4 refers to the depth from the surface of the impurity diffusion layer 4 to the p-n junction. The depth of the p-n junction may be the depth from the surface of the impurity diffusion layer 4 until the impurity concentration in the impurity diffusion layer 4 becomes the impurity concentration of the substrate.

The method of manufacturing the solar cell of the present embodiment includes a step of forming a back side electrode 15 so as to be electrically connected to the other surface of the semiconductor substrate of the first conductivity type (the n-type crystalline silicon substrate). The back side electrode 15 may be either before or after the formation of the light incident side surface-electrode 20. The firing for forming the back side electrode 15 may be performed simultaneously with or separately from the firing for forming the light incident side surface-electrode 20.

Specifically, the method of manufacturing the crystalline silicon solar cell of the present embodiment forms the back side electrode 15 by printing a conductive paste on the other surface (the back surface) of the crystalline silicon substrate 1 and firing.

In the case of manufacturing a bifacial crystal solar cell as shown in Fig. 4, the second impurity diffusion layer 16 can be formed. On the other hand, by forming the back side electrode 15 using the conductive paste (the conductive composition) of the present embodiment and performing a laser treatment process, a low-resistance conductive portion can be formed between the back side electrode 15 and the crystal silicon substrate 1. Therefore, in the case of a bifacial crystal solar cell, it is preferable to form the back side electrode 15 using the conductive paste of the present embodiment. In this case, the back side electrode 15 is a fired body of the conductive paste of the present embodiment.

Next, the manufacturing method of the solar cell of the present embodiment includes forming a passivation film so as to contact the surface of the semiconductor layer (impurity diffusion layer 4) of the second conductivity type. The passivation film may be an antireflection film 2.

More specifically, the manufacturing method of the crystalline silicon solar cell of the present embodiment forms an antireflection film 2, which also functions as a passivation film, on the surface of the impurity diffusion layer 4 formed in the above step. As the antireflection film 2, a silicon nitride film (a SiN film) can be formed. When the silicon nitride film is used as the antireflection film 2, the layer of the silicon nitride film also has a function of a passivation film for the light incident side surface. Therefore, when the silicon nitride film is used as the antireflection film 2, a high-performance crystalline silicon solar cell can be obtained. In addition, since the antireflection film 2 is a silicon nitride film, an antireflection function can be exhibited to incident light. The silicon nitride film can be formed by a PECVD (Plasma Enhanced Chemical Vapor Deposition) method or the like.

The manufacturing method of the solar cell of the present embodiment includes a step of forming a light incident side surface-electrode 20 on at least a part of the surface of the passivation film (the antireflection film 2). In the manufacturing method of the present embodiment, the conductive paste described above is used for forming the light incident side surface-electrode 20. Therefore, the light incident side surface-electrode 20 is a fired body of the conductive paste described above.

In the method for producing the crystalline silicon solar cell of the present embodiment, the conductive paste is printed on the surface of the antireflection film 2 and fired to form the light incident side surface-electrode 20. When firing for forming the light incident side surface-electrode 20, firing for forming the back side electrode 15 can be performed at the same time.

Specifically, first, a pattern of the light incident side surface-electrode 20 printed using the conductive paste of the present embodiment is dried at a temperature of about 100 to 150 degree C for several minutes (for example, 0.5 to 5 minutes). At this time, the light incident side bus bar electrode 20a and the light incident side finger electrode 20b of the light incident side surface-electrode 20 can be formed using the conductive paste of the present embodiment.

Following printing and drying of the pattern of the light incident side surface-electrode 20, a conductive paste for forming a back side electrode 15 is printed and dried. The conductive paste of the present embodiment can be preferably used to form the electrode (the light incident side surface-electrode 20 and possibly the back side electrode 15) of the solar cell such as the crystalline silicon solar cell.

Thereafter, the printed conductive paste is dried and fired under predetermined firing conditions in air using a firing furnace such as a tubular furnace. As the firing conditions, the firing atmosphere is in air, and the firing temperature is 500 to 1000 degree C, more preferably 600 to 1000 degree C, further more preferably 500 to 900 degree C, and particularly preferably 700 to 900 degree C. The firing is preferably performed in a short time, and the temperature profile (temperature-time curve) during firing is preferably peak-like. For example, with the aforementioned temperature as the peak temperature, the in-out time of the firing furnace is preferably 10 to 100 seconds, more preferably 20 to 80 seconds, and further more preferably 40 to 60 seconds.

During firing, the conductive paste for forming the light incident side surface-electrode 20 and the back side electrode 15 is preferably fired simultaneously to form both electrodes simultaneously. By printing the predetermined conductive paste on the light incident side surface and the back side surface and firing them simultaneously, only one firing for forming the electrodes can be performed. Therefore, the crystalline silicon solar cell can be manufactured at a lower cost.

The manufacturing method of the solar cell of the present embodiment includes performing the laser treatment process described above. That is, the manufacturing method of the solar cell of the present embodiment includes irradiating the light incident side surface of the solar cell with light (e.g., laser light) from a point light source while applying a voltage between the back side electrode 15 and the light incident side surface-electrode 20 so that an electric current flows between the semiconductor layer of the second conductivity type (the p-type impurity diffusion layer 4) and the semiconductor substrate of the first conductivity type (the n-type crystalline silicon substrate 1) in a direction opposite to the forward bias direction. The laser treatment process enables good electrical conduction between the light incident side surface-electrode 20 and the impurity diffusion layer 4.

As described above, the crystalline silicon solar cell of the present embodiment can be produced.

The crystalline silicon solar cell of the present embodiment obtained as described above can be electrically connected with a metal ribbon for interconnection and laminated with a glass plate, a sealant, a protective sheet, or the like to obtain a solar cell module. As the metal ribbon for interconnection, a metal ribbon (for example, ribbons made of copper) whose periphery is covered with solder can be used. As the solder, commercially available solders such as those mainly containing tin, specifically leaded solder and lead-free solder can be used.

In the crystalline silicon solar cell of the present embodiment, the predetermined electrode of the solar cell is formed using the conductive paste of the present embodiment, and the laser treatment process is performed to obtain a crystalline silicon solar cell with high performance.

EXAMPLE

Hereinafter, the present embodiment will be specifically described with reference to Examples, but the present invention is not limited thereto.

In Examples and Comparative Examples, the degree of degradation of the passivation film by the photoluminescence imaging method (PL method) and the contact resistance and specific resistance of the formed electrodes were evaluated using substrates for measurements, which are simulating single crystalline silicon solar cells, and the performance of the conductive pastes of Examples and Comparative Examples of the present embodiment was evaluated.

<Material and Preparation Ratio of the Conductive Paste>

Tables 1 to 3 show the compositions of the conductive pastes of Example 1 to 14 and Comparative Examples 1 to 4. The compositions shown in Tables 1 to 3 and the compositions of the following components are shown as parts by weight of each component when silver particles (A) are 100 parts by weight. The components contained in the conductive paste are as follows.

Silver particles (A)

Table 4 shows part numbers, manufacturers, shape, average particle size (D50), TAP density, and BET specific surface area of silver particles A1 and A2 used in the conductive pastes of Examples and Comparative Examples. Tables 1 to 3 show the amount of silver particles A1 and A2 used in the conductive pastes of Examples and Comparative Examples.

The average particle size (D50) was determined by measuring of particle size distribution by the micro-track method (laser diffraction scattering method) and obtaining the value of the median diameter (D50) from the result of the measurement of particle size distribution. The same applies to the average particle size (D50) of the other components. For the measurement of BET specific surface area, a full-automatic specific surface area measuring device Macsoeb (manufactured by MOUNTEC) was used. The BET specific surface area was measured by BET one point method using nitrogen gas adsorption after pre-drying at 100 degree C and flowing nitrogen gas for 10 minutes.

Organic vehicle (B)

Organic binder and solvent were used as the organic vehicle. Ethylcellulose (0.4 parts by weight) having an ethoxy content of 48 to 49.5 weight % was used as the organic binder. Diethylene glycol monobutyl ether acetate (butyl carbitol acetate) (3 parts by weight) was used as the solvent.

Glass frit (C)

Table 5 shows the compositions, basicity and glass transition temperature of glass frits A to G used for the conductive pastes of Examples and Comparative Examples. The average particle size (D50) of the glass frits A to G was 2 $\mu$m. Tables 1 to 3 shows the type (any of A to G) and the content G (parts by weight) of the glass frit (C) of the conductive pastes of Examples and Comparative Examples.

The glass transition temperature of the glass frits A to G was measured. Table 5 shows the measured glass transition temperature of the glass frits A to G. The glass transition temperature of the glass frits was measured as follows. About 50 mg of the glass frits A to G were placed in a platinum cell as samples, and the DTA curve was obtained using alumina powder as a standard sample at a heating rate of 20 degree C/min from room temperature to 800 degree C under air atmosphere using a differential thermal analyzer (Made by Rigaku Corporation, TG-8120). The starting point of the first endotherm (extrapolation point) of the DTA curve was set as the glass transition temperature.

The glass frits A to G were produced as follows. First, oxide powder as a raw material was weighed, mixed, and charged into a crucible. The crucible was placed in a heated oven, and the contents of the crucible were heated up to the melt temperature and maintained at the melt temperature until the raw material was sufficiently melted. Next, the crucible was removed from the oven, and the melted contents were stirred uniformly. Next, the contents of the crucible were quenched at room temperature using two stainless steel rolls to obtain plate-like glass. Finally, the plate-like glass was uniformly dispersed by grinding with a mortar, and the glass frit with the desired grain size was obtained by sieving with a mesh sieve. A glass frit with an average particle size (D50) of 149 $\mu$m was obtained by sieving through a 100 mesh sieve and into those remaining on a 200 mesh sieve. By further grinding the glass frit, a glass frit with an average particle size (D50) of 2 $\mu$m was obtained.

Aluminum particles (D)

Table 6 shows part numbers, a manufacturer, shape, and average particle size (D50) of aluminum particles D1 and D2 used in the conductive pastes of Examples and Comparative Examples. Tables 1 to 3 shows the amounts (parts by weight) of the aluminum particles D1 and D2 used in the conductive pastes of Examples and Comparative Examples.

Next, the conductive pastes of Examples and Comparative Examples were prepared by mixing the materials in the weight ratio shown in Tables 1 to 3 in a planetary mixer, dispersing them in a three-roll mill, and forming a paste.

<Evaluation of Reactivity of Conductive Paste to Passivation Film by PL Method>

Reactivity of the conductive pastes to the passivation films was evaluated by the photoluminescence imaging method (referred to "PL method"). The PL method can be used to evaluate the reactivity of conductive paste to a passivation film in a nondestructive and non-contact manner and in a short period of time. More specifically, the PL method consists of irradiating a sample with light having energy greater than the band gap to cause the sample to emit light. and evaluating the state of crystal defects as well as surface and interface defects based on the status of the emitted light. In the case the sample has defects and surface/interface defects in the single crystal silicon substrate, the defects act as recombination centers of electron-hole pairs generated as a result of being irradiated with light, resulting in a corresponding decrease in band-edge emission intensity attributable to photoluminescence. In other words, in the case the passivation film has been eroded by the printed/fired electrodes and surface defects have formed at the interface between the passivation film and the single crystal silicon substrate (namely, surface of the single crystal silicon substrate), the emission intensity of photoluminescence decreases at those portions where surface defects have formed (namely, those portions where electrodes have been formed on the sample). The magnitude of this photoluminescence emission intensity can be used to evaluate reactivity of an experimentally produced conductive paste to a passivation film.

The fabrication method of the substrate for evaluation by the PL method is as follows.

An n-type single crystalline silicon substrate (substrate thickness: 200 $\mu$m) was used as the substrate.

First, a silicon oxide layer of about 20 $\mu$m was formed on the substrate by dry oxidation, and then it was etched with a mixed solution of hydrogen fluoride, pure water, and ammonium fluoride to remove the damage on the substrate surface. Then, heavy metal cleaning was performed with an aqueous solution containing hydrochloric acid and hydrogen peroxide.

Next, a texture structure (uneven shape) was formed on both surfaces of the substrate by wet etching. Specifically, a pyramid-like texture structure was formed on both surfaces (the light incident side surface and the back surface) by wet etching (sodium hydroxide aqueous solution). Then, the substrate was cleaned with an aqueous solution containing hydrochloric acid and hydrogen peroxide. Next, boron was implanted into one surface (the light incident side surface) of the substrate having a texture structure to form a p-type diffusion layer to a depth of about 0.5 $\mu$m. The sheet resistance of the p-type diffusion layer was 60 $\Omega/\square$. Phosphorus was implanted into the other surface (the back surface) of the substrate having a texture structure to form an n-type diffusion layer to a depth of about 0.5 $\mu$m. The sheet resistance of the n-type **diffusion** layer was 20 $\Omega/\square$. Boron and phosphorus were implanted simultaneously by the thermal diffusion method.

Next, after a thin oxide layer of 1 to 2 nm was formed on the surface (the light incident side surface) of the substrate on which the p-type diffusion layer was formed, and on the surface (the back surface) of the substrate on which the n-type diffusion layer was formed, a silicon nitride film was formed to a thickness of about 60 nm by plasma CVD using silane gas and ammonia gas. Specifically, a silicon nitride film (an antireflection film 2) with a thickness of about 70 nm was formed by plasma CVD by glow discharge decomposition of a 1 Torr (133 Pa) mixed gas of $NH_3/SiH_4 = 0.5$.

The substrate thus obtained was cut into squares of 25 mm $\times$ 25 mm to prepare a substrate 1.

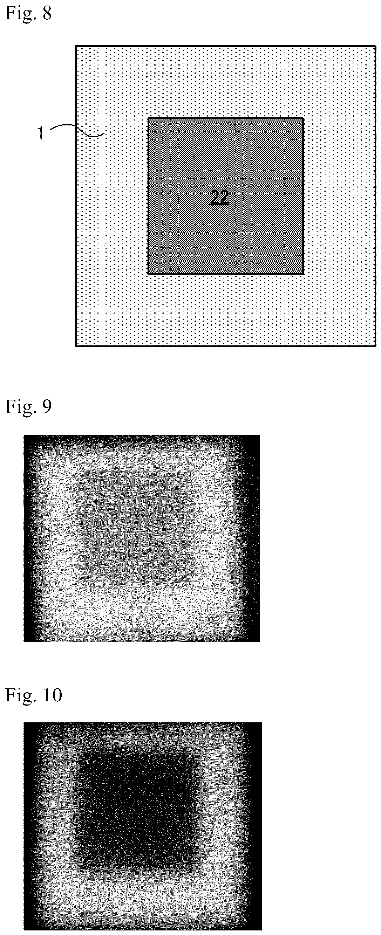

Next, as shown in Fig. 8, a square electrode pattern 22 of 13 mm $\times$ 13 mm was printed on the surface of the substrate 1 using conductive paste for electrode formation and dried.

The substrate 1 having the electrode pattern 22 printed on its surface by the conductive paste as described above was fired using a firing furnace CDF7210 manufactured by Despatch Industries, Inc., at a peak temperature of 720 degree C and in-out time of the firing furnace of 50 seconds.

The substrate (the sample) for measurement by the PL method was prepared as described above.

Measurement by the PL method was performed using a Photoluminescence Imaging System (model number: LIS-R2) manufactured by BT Imaging Pty. Ltd. The back surface (the surface on which the light incident side surface-electrode 20 does not formed) of the substrate was irradiated with light from a light source (wavelength of 650 nm, 3 mW output) for excitation, and an image of the emission intensity of photoluminescence was obtained.

Figs. 9 and 10 show images of the emission intensity of photoluminescence measured by the PL method.

Fig. 9 shows an image of the emission intensity of photoluminescence measured by the PL method of a sample in which the electrode pattern 22 was formed using the conductive paste of Example 4. As is clear from Fig. 9, the image of the portion where the electrode pattern 22 is formed is brighter than that of Fig. 10 described later. This indicates that the decrease in the emission intensity of the photoluminescence of the portion where the electrode pattern of the light incident side surface-electrode 20 is formed is suppressed. Therefore, in the case of the sample shown in Fig. 9, it can be said that the function of passivation by the passivation film is maintained by forming the electrode pattern of the light incident side surface-electrode 20. Therefore, in the case of the sample using the conductive paste of Example 4 shown in Fig. 9, it can be said that the density of surface defect of the surface of the single crystalline silicon substrate 1 is not increased.

On the other hand, the conductive paste of Comparative Example 1 was used to form the light incident side surface-electrode 20 for the preparation of a sample shown in Fig. 10. As is clear from Fig. 10, the image of the portion where the electrode pattern of the light incident side surface-electrode 20 is formed is darker than that of the sample shown in Fig. 9. This indicates that the emission intensity of the photoluminescence of the portion where the electrode pattern of the light incident side surface-electrode 20 is formed is decreased. Therefore, in the case of the sample using the conductive paste of Comparative Example 1 shown in Fig. 10, by forming the electrode pattern of the light incident side surface-electrode 20, it can be said that the function of passivation by the passivation film is impaired and the density of surface defect of the surface of the single crystalline silicon substrate 1 is increased.

Table 1 to Table 3 show the measured values (PL values) of the photoluminescence emission intensities of Examples and Comparative Examples. The PL values are the average value of the photoluminescence emission intensity near the electrode. The PL value is a numerical value that varies depending on the spectrum and intensity of the irradiation light from the light source for excitation and the optical system for measurement, and the PL value is a value in an arbitrary unit. When the conditions for measuring the PL value such as the spectrum and intensity of the irradiation light and the optical system for measurement are the same, it can be said that the degree of carrier recombination (the degree of deterioration of the passivation function) in each sample can be evaluated by comparing the magnitude of the PL value of each sample. The higher the PL value, the better the passivation function by the passivation film.

For confirmation, cross-sections of the samples shown in Figs. 9 and 10 were observed by scanning electron microscope (SEM). Fig. 11 shows a cross-sectional SEM photograph (magnification: 20,000 times) of the sample (corresponding to Example 4) where the light incident side surface-electrode 20 was formed under the same conditions using the same conductive paste as the sample shown in Fig. 9. Fig. 12 shows a cross-sectional SEM photograph (magnification: 20,000 times) of the sample (corresponding to Comparative Example 1) where the light incident side surface-electrode 20 was formed under the same conditions using the same conductive paste as the sample shown in Fig. 10. As is clear from Fig. 11, in the case of a sample with a high PL value, the antireflection film 2 (passivation film) maintained its almost unchanged shape after the formation of the light incident side surface-electrode 20, and the antireflection film 2 (the passivation film) was not eroded by the glass frit. On the other hand, as is clear from Fig. 12, in the case of a sample having a low PL value, the antireflection film 2 (the passivation film) is eroded by the glass frit, and most of the antireflection film 2 (the passivation film) disappears. That is, it can be said that the conductive paste in Comparative Example 1 is a conductive paste capable of firing through the passivation film. The portion labeled "Glass" in Fig. 12 is a glass component caused by the glass frit contained in the conductive paste. From the above, it is clear that the presence or absence of reactivity of the conductive paste to the antireflection film 2 (the passivation film) can be evaluated by measuring the PL value by the PL method described above.

As is clear from Tables 1 to 3, the PL values of the samples obtained by using the conductive paste (the conductive composition) of Examples 1 to 14 of the present embodiment was 5522 (Example 2) or more. In contrast, the PL value of Comparative Example 1 was 4900, and the PL value of Comparative Example 2 was as low as 4800. Therefore, the function of the passivation by the passivation film in Comparative Examples 1 and 2 is lower than that in the Examples of the present embodiment, so that the performance of the solar cell is degraded in Comparative Examples 1 and 2. This also suggests that, among solar cell characteristics, open circuit voltage (Voc) is degraded when the electrode is formed by using the conductive paste of Comparative Examples 1 and 2.

SEM observation of the cross-section near the interface between the electrode and the silicon substrate of the sample of Comparative Example 2 having a PL value of 4800 confirmed that antireflection film 2 (the passivation film) did not remain in the sample of Comparative Example 2, which is the same as in Comparative Example 1 having a PL value of 4900 (See Fig. 12). On the other hand, SEM observation of the cross-section near the interface between the electrode and the silicon substrate of the sample of Example 2 having a PL value of 5522 confirmed that antireflection film 2 (the passivation film) remained in the sample of Example 2 between the electrode and the silicon substrate, which is the same as in Example 4 (See Fig. 11). Therefore, from the evaluation results by the photoluminescence imaging method (PL method) used for the evaluation of Example 1 to 14 and Comparative Examples 1 to 4, it became clear that when the PL value is 5000 or more, preferably when the PL value is 5500 or more, an antireflection film 2 (a passivation film) remains between the electrode and the silicon substrate, and solar cells with high performance (in particular, high Voc) can be expected to be obtained.

It was confirmed that the PL value did not significantly change before and after the laser treatment process. It is considered that this is because the treatment by the laser treatment process is a treatment for locally forming small electrically conductive portions, and does not affect most of the antireflection film 2 (the passivation film).

<Measurement of Contact Resistance Before Laser Treatment Process>

Similar to the sample for the measurement by the PL method, a p-type impurity diffusion layer was formed on one surface of an n-type crystalline silicon substrate (substrate thickness: 200 $\mu$m), and a silicon nitride film (an antireflection film 2 that is a passivation film) with a thickness of about 60 nm was formed on the p-type impurity diffusion layer to obtain a substrate for the measurement of contact resistance.

The conductive pastes of Examples and Comparative Examples for forming the electrodes on the surfaces (the light incident side surface) of the substrates on which the p-type diffusion layers were formed in the single crystalline silicon solar cells were as shown in Tables 1 to 3.

The conductive paste was printed by the screen printing method. A pattern consisting of a light incident side bus bar electrode 20a of 1.5 mm width and a light incident side finger electrode 20b of 60 $\mu$m width was printed on the antireflection film 2 of the above-described substrate so that the film thickness was about 20 $\mu$m, and the pattern was then dried at 150 degree C for about 1 minute.

A commercially available Ag paste was printed as a back side electrode 15 (an electrode on the surface on which the n-type diffusion layer was formed) by the screen printing method. The electrode pattern of the back side electrode 15 was the same as that of the light incident side electrode 20. The film was then dried at 150 degree C for about 60 seconds. The thickness of the conductive paste for the back side electrode 15 after drying was about 20 $\mu$m. Thereafter, both surfaces were simultaneously fired at a peak temperature of 720 degree C and in-out time of the firing furnace of 50 seconds using a belt furnace (a firing furnace) CDF7210 manufactured by Despatch Industries, Inc. The single crystalline silicon solar cell was prepared as described above.

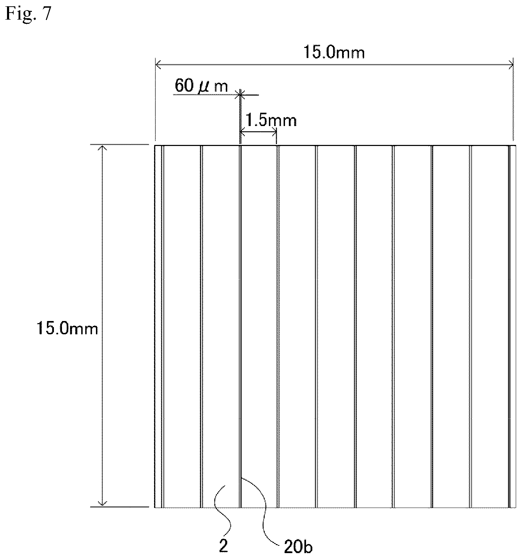

The solar cell thus obtained was cut into squares of 15 mm $\times$ 15 mm as shown in Fig. 7 to obtain a sample for contact resistance measurement. As shown in Fig. 7, light incident side finger electrodes 20b having a width of 60 $\mu$m and a length of 15.0 mm were arranged at intervals of 1.5 mm on the light incident side surface of the cut solar cell (the sample for the contact resistance measurement). This light incident side finger electrode 20b was used as a pattern for contact resistance measurement. The contact resistance of the pattern for contact resistance measurement in Examples and Comparative Examples before the laser treatment process was obtained by the TLM method (Transfer Length Method) using a GP4 TEST Pro manufactured by GP Solar.

As a sample for contact resistance measurement, three samples under the same conditions were prepared, and the measured value was obtained as an average value of the 3 samples.

<Measurement of Contact Resistance After Laser Treatment Process>

Similar to the measurement of contact resistance before the laser treatment process described above, a single crystalline silicon solar cell was produced, and a laser treatment process was performed on the light incident side surface of the solar cell. That is, laser light was irradiated to the light incident side surface of the solar cell while applying a negative voltage to the back side electrode 15 and a positive voltage to each of the light incident side electrodes 20 of the pattern shown in Fig. 2 formed on the light incident side surface so that an electric current flows between the p-type impurity diffusion layer 4 of the solar cell and the n-type crystalline silicon substrate 1 in a direction opposite to the forward bias direction . The applied voltage during the laser treatment process was 20 V, the irradiated laser light intensity was 100 W/cm$^2$, and the application of the voltage and the irradiation time of the laser light was 2 seconds.

The solar cell thus obtained was cut into a square of 15 mm $\times$ 15 mm as shown in Fig. 7, and the contact resistance after the laser treatment process was determined by the same method as the contact resistance measurement before the laser treatment process.

First, when the value of the contact resistance before the laser treatment process is 450 m$\Omega \cdot$cm$^2$ or less, it can be used as an electrode of the solar cell by the laser treatment process. Similarly, when the contact resistance is 300 $\Omega \cdot$cm$^2$ or less, it can be more preferably used as an electrode of the solar cell by the laser treatment process.

Next, when the value of the contact resistance after the laser treatment process is 20 m$\Omega \cdot$cm$^2$ or less, it can be preferably used as an electrode of the solar cell 20. Similarly, a contact resistance of 9 m$\Omega \cdot$cm$^2$ or less is more preferably used as an electrode of a solar cell.

As is clear from Tables 1 to 3, the contact resistance of the samples obtained using the conductive pastes (the conductive compositions) of Examples 1 to 14 of the present embodiment before the laser treatment process was 440 m$\Omega \cdot$cm$^2$ (Example 1) or less. In contrast, the contact resistance of Comparative Example 3 was 640 m$\Omega \cdot$cm$^2$, and the contact resistance of Comparative Example 4 was as high as 804 m$\Omega \cdot$cm$^2$. In addition, the contact resistance of the samples obtained using the conductive paste (the conductive compositions) of Examples 1 to 14 of the present embodiment after the laser treatment process was 18 m$\Omega \cdot$cm$^2$ (Example 1) or less. In contrast, the contact resistance of Comparative Example 3 was 21 m$\Omega \cdot$cm$^2$, and the contact resistance of Comparative Example 4 was as high as 32 m$\Omega \cdot$cm$^2$. Therefore, since the contact resistance of Comparative Examples 3 and 4 is higher than that of Examples of the present embodiment, it can be said that the performance of the solar cell is degraded. That is, in the case of Comparative Examples 3 and 4, it can be said that they cannot be preferably used as electrodes of the solar cells.

[Measurement of Specific Resistance]

The specific resistance of the conductive film patterns for specific resistance measurement obtained by firing the conductive pastes of Examples and Comparative Examples were measured.

The specific resistance of Examples and Comparative Examples was measured by the following procedure. That is, a silicon substrate having a width of 15 mm, a length of 15 mm, and a thickness of 180 $\mu$m was prepared. On this substrate, a pattern consisting of conductive paste as shown in Fig. 6 was printed using a 325 mesh stainless steel screen.

Next, the silicon substrates coated on the substrates and having the patterns of Examples and Comparative Examples printed on their surfaces were simultaneously fired on both surfaces at a peak temperature of 720 degree C and in-out time of the firing furnace of 50 seconds using a firing furnace CDF7210 manufactured by Despatch Industries, Inc. The samples for specific resistance measurement were prepared as described above.

The specific resistance of the conductive film patterns of the samples for specific resistance measurement obtained by firing the conductive pastes of Examples and Comparative Examples was measured. First, the resistance value was measured by the 4-terminal method using a type 2001 multimeter manufactured by Toyo Corporation. The cross-sectional area of the conductive film pattern was measured using a confocal microscope OPTELICS H1200 manufactured by Lasertec Corporation and a surface roughness profiler 1500SD2. Fifty places in a range of 1.6 mm were measured, and the average value was obtained. The specific resistance was calculated using the cross-sectional area and the measured resistance value.

Four samples under the same condition were prepared as samples for measuring the specific resistance, and the measured value was obtained as an average value of the four samples. The measurement results are shown in Tables 1 to 3.

As is clear from Tables 1 to 3, the specific resistance of the conductive films obtained using the conductive pastes (the conductive compositions) of Examples 1 to 14 of the present embodiment and Comparative Examples 1 to 4 was 8 $\mu\Omega\cdot$cm (Examples 11 and 18) or less. In general, it can be said that a specific resistance of 15 $\mu\Omega\cdot$cm or less can be suitably used as an electrode. Therefore, by using the conductive paste of the present embodiment, it can be said that an electrode having a preferable specific resistance can be obtained.

As described above, when the conductive pastes of Comparative Examples 1 and 2 were used, there is a problem that the PL value is low. Moreover, when the conductive pastes of Comparative Examples 3 and 4 are used, there is a problem that the contact resistance between the electrode and the impurity diffusion layer is high. Therefore, it is obvious that a high-performance solar cell cannot be produced when the conductive pastes of Comparative Examples 1 to 4 are used.

On the other hand, in the case of the electrodes formed using the conductive pastes of the present embodiment, the PL values are sufficiently high, the contact resistance is low, and the specific resistance is also low. Therefore, it can be said that a crystalline silicon solar cell with high performance can be obtained by using the conductive paste of the present embodiment.

As described above, in the case of the electrode formed using the conductive paste of the present embodiment, it was confirmed that the contact resistance is low by performing the laser treatment process. When the contact resistance is low, the fill factor (FF) increases. In addition, from the result of the evaluation by the PL method described above, when the conductive paste of the present embodiment is used, since the remaining ratio of the antireflection film 2 (the passivation film) between the electrode 20 and the impurity diffusion layer 4 is high, the recombination of carriers is suppressed low. Therefore, when the conductive paste of the present embodiment is used, it can be said that a risk of lowering of the open circuit voltage (Voc) is low. From the above, it can be said that when the electrode is formed using the conductive paste of the present embodiment, the solar cell having the characteristic that the fill factor (FF) can be improved without lowering the open circuit voltage (Voc) can be obtained.

Fig. 13 shows an SEM photograph (magnification: 20,000 times) of a solar cell prepared under the same conditions as in Example 5 and observed by scanning electron microscope (SEM) at a high magnification in the cross-section after the laser treatment process. As shown in Fig. 13, it can be understood that AgSi alloy 30 (a local conductive portion), which is a local small electrically conductive portion (the local conductive portion), is formed in the impurity diffusion layer 4 (the silicon emitter layer) in contact with the light incident side surface-electrode of the solar cell prepared under the same conditions as in Example 5. Since the conductive paste of the present embodiment was used to form the electrode (the light incident side surface-electrode 20) in the solar cell of the present embodiment, it can be said that the local conductive portion could be formed in the impurity diffusion layer 4. Therefore, by forming the electrode (the light incident side surface-electrode 20) using the conductive paste of the present embodiment, it can be said that a low contact resistance can be obtained between the electrode and the impurity diffusion layer 4 of the solar cell.

Table 1

| (Content is in parts by weight) | | Comparative Example 1 | Comparative Example 2 | Comparative Example 3 | Comparative Example 4 | Example 1 | Example 2 |
|---|---|---|---|---|---|---|---|
| Conductive particles (A) | Conductive particles A1 | 100 | 100 | 100 | 100 | 100 | 100 |
| | Conductive particles A2 | | | | | | |
| Glass frit (C) | (C) Type | B | C | D | E | A | A |
| | (C) Content G | 5.0 | 2.0 | 1.0 | 0.5 | 0.5 | 2.0 |
| Al particles (D) | Al particle D1 | 2.0 | 2.0 | 2.0 | 2.0 | 1.0 | 1.0 |
| | Al particles D2 | | | | | | |
| Basicity $B_{GF}\times$ (C) Content G | | 1.50 | 1.60 | 0.20 | 0.19 | 0.34 | 1.36 |
| PbO Content $C_{PbO}$ (mol%) $\times$ (C) Content G | | 140 | 144 | 18 | 16 | 26 | 102 |
| PL Value | | 4900 | 4800 | 32000 | 28200 | 17600 | 5522 |

(continued)

| (Content is in parts by weight) | Comparative Example 1 | Comparative Example 2 | Comparative Example 3 | Comparative Example 4 | Example 1 | Example 2 |
|---|---|---|---|---|---|---|
| Contact resistance before laser treatment process (m$\Omega\cdot$cm$^2$) | 120 | 12 | 640 | 804 | 440 | 78 |
| **Specific resistance** ($\mu\Omega\cdot$cm) | 6 | 6 | 6 | 8 | 7 | 6 |
| Contact resistance after laser treatment **process** (**m$\Omega\cdot$cm$^2$**) | 3 | 2 | 21 | 32 | 18 | 3 |

Table 2

| (Content is in parts by weight) | | Example 3 | Example 4 | Example 5 | Example 6 | Example 7 | Example 8 |
|---|---|---|---|---|---|---|---|
| Conductive particles (A) | Conductive particles A1 | 100 | 100 | 100 | 100 | 100 | 100 |
| | Conductive particles A2 | | | | | | |
| Glass frit (C) | (C) Type | A | A | A | A | A | F |
| | (C) Content G | 2.0 | 1.0 | 1.0 | 1.0 | 0.5 | 1.0 |
| Al particles (D) | Al particles D1 | 2.0 | 1.0 | - | 2.0 | 2.0 | 2.0 |
| | Al particles D2 | | | | | | |
| Basicity B$_{GF}\times$ (C) Content G | | 1.36 | 0.68 | 0.68 | 0.68 | 0.34 | 0.61 |
| PbO Content C$_{PbO}$ (mol%) $\times$ (C) Content G | | 102 | 51 | 51 | 51 | 26 | 52 |
| PL value | | 6500 | 9868 | 8600 | 11480 | 20090 | 9315 |
| Contact resistance before laser treatment process (m$\Omega\cdot$cm$^2$) | | 16 | 289 | 374 | 35 | 140 | 293 |
| **Specific resistance** ($\mu\Omega\cdot$cm) | | 7 | 6 | 5 | 7 | 8 | 7 |
| Contact resistance after laser **treatment process** (**m$\Omega\cdot$cm$^2$**) | | 2 | 6 | 14 | 2 | 3 | 6 |

Table 3

| (Content is in parts by weight) | | Example 9 | Example 10 | Example 11 | Example 12 | Example 13 | Example 14 |
|---|---|---|---|---|---|---|---|
| Conductive particles (A) | Conductive particles A1 | 100 | 100 | 100 | 100 | | 100 |
| | Conductive particles A2 | | | | | 100 | |
| Glass frit (C) | (C) Type | G | E | E | E | A | A |
| | (C) Content G | 1.0 | 1.0 | 2.0 | 3.0 | 1.0 | 1.0 |
| Al particles (D) | Al particle D1 | 2.0 | 2.0 | 2.0 | 2.0 | 2.0 | |
| | Al particles D2 | | | | | | 2.0 |
| Basicity B$_{GF}\times$ (C) Content G | | 0.68 | 0.38 | 0.76 | 1.14 | 0.68 | 0.68 |
| PbO Content C$_{PbO}$ (mol%) $\times$ (C) Content G | | 54 | 32 | 64 | 96 | 51 | 51 |

(continued)

| (Content is in parts by weight) | Example 9 | Example 10 | Example 11 | Example 12 | Example 13 | Example 14 |
|---|---|---|---|---|---|---|
| PL value | 10370 | 27140 | 20300 | 11070 | 10700 | 10420 |
| Contact resistance before laser treatment process ($m\Omega \cdot cm^2$) | 58 | 425 | 326 | 174 | 50 | 90 |
| **Specific Resistance** ($\mu\Omega \cdot cm$) | 7 | 7 | 7 | 7 | 7 | 8 |
| Contact resistance after laser **treatment process** ($m\Omega \cdot cm^2$) | 3 | 17 | 12 | 4 | 2 | 3 |

Table 4

| | Part No. | Manufacturer | Shape | Average particle size **D:50** ($\mu m$) | TAP density ($g/cm^3$) | **BET** Specific surface area ($m^2/g$) |
|---|---|---|---|---|---|---|
| Silver particles A1 | AG-SNA-190 | DOWA Electronics | Spherical | 2 | 5 | 0.4 |
| Silver particles A2 | AG-SNA-188 | DOWA Electronics | Spherical | 1 | 5 | 1 |

Table 5

| Types of glass frit (C) | Glass frit A | Glass frit B | Glass frit C | Glass frit D | Glass frit E | Glass frit F | Glass Frit G |
|---|---|---|---|---|---|---|---|
| PbO (mol%) | 51.0 | 28.0 | 72.0 | 18.0 | 32.0 | 52.0 | 54.0 |
| $SiO_2$ (mol%) | 31.0 | 62.0 | 18.0 | 72.0 | 58.0 | 37.0 | 28.0 |
| $Al_2O_3$ (mol%) | 4.0 | | | | 0.5 | 4.0 | 4.0 |
| $B_2O_3$ (mol%) | 4.0 | 10.0 | 10.0 | 10.0 | 9.5 | 4.0 | 4.0 |
| ZnO (mol%) | 10.0 | | | | | | 10.0 |
| $V_2O_5$ (mol%) | | | | | | 1.0 | |
| $WO_3$ (mol%) | | | | | | 1.0 | |
| $Nb_2O_3$ (mol%) | | | | | | 1.0 | |
| Total (mol%) | 100.0 | 100.0 | 100.0 | 100.0 | 100.0 | 100.0 | 100.0 |
| Basicity $B_{GF}$ | 0.68 | 0.30 | 0.80 | 0.20 | 0.38 | 0.61 | 0.68 |
| Glass transition temperature (degree C) | 356 | 462 | 320 | 542 | 449 | 405 | 394 |

Table 6

| | Part No. | Manufacturer | Shape | Average particle diameter **D:50** ($\mu m$) |
|---|---|---|---|---|
| Al particle D1 | TFH-A02P | Toyo Aluminum | Spherical | 2 |
| Al Particle D2 | TFH-A05P | Toyo Aluminum | Spherical | 5 |

Description of Reference Numerals

1: Crystalline silicon substrate

2: Antireflection film (Passivation film)

4: Impurity diffusion layer

14: Back side passivation film

15: Back side electrode

15a: Back side TAB electrode (Back side bus bar electrode)

15b: Back side electrode (Back side full-surface electrode)

15c: Back side finger electrode

16: Second impurity diffusion layer

20: Light incident side surface-electrode (Front surface electrode)

20a: Light incident side bus bar electrode

20b: Light incident side finger electrode

22: Electrode pattern

30: AgSi Alloy (Local conductive portion)

**Claims**

1.   A conductive paste for forming an electrode of a solar cell, comprising:

   conductive particles (A);
   an organic vehicle (B); and
   a glass frit (C),
   wherein a product $B_{GF} \cdot G$ of a basicity $B_{GF}$ of the glass frit (C) and a content G of the glass frit (C) is in a range of 0.25 to 1.45, and the content G of the glass frit (C) is in an unit of part by weight in the conductive paste when a content of the conductive particles (A) in the conductive paste is 100 parts by weight.

2.   The conductive paste according to claim 1, wherein the conductive particles (A) comprise silver particles.

3.   The conductive paste according to claim 1 or 2, wherein the organic vehicle (B) comprises at least one selected from an ethyl cellulose, a rosin ester, an acryl and an organic solvent.

4.   The conductive paste according to any one of claims 1 to 3, wherein a product $C_{PbO} \cdot G$ of a content $C_{PbO}$ of PbO and the content G of the glass frit (C) is in a range of 20 to 139, and the content $C_{PbO}$ is in an unit of mol% in the glass frit (C).

5.   The conductive paste according to any one of claims 1 to 4, wherein the content G of the glass frit (C) is 0.3 to 4.0 parts by weight.

6.   The conductive paste according to any one of claims 1 to 4, wherein the content G of the glass frit (C) is 0.5 to 1.5 parts by weight.

7.   A conductive paste according to any one of claims 1 to 6, wherein the glass transition temperature of the glass frit (C) is 300 to 600 degree C.

8.   A conductive paste according to one of claims 1 to 7, wherein the glass frit (C) comprises at least one selected from ZnO, $V_2O_5$, $WO_3$ and $Nb_2O_3$.

9.   A conductive paste according to any one of claims 1 to 8, wherein the conductive paste further comprises aluminum particles (D).

10. A conductive paste according to claim 9, wherein a content of the aluminum particles (D) in the conductive paste is 0.1 to 2.0 parts by weight, when the content of the conductive particles (A) in the conductive paste is 100 parts by weight.

11. A conductive paste according to any one of claims 1 to 10 for forming an electrode of a solar cell, wherein the solar cell comprises:

a semiconductor substrate of a first conductivity type;
a semiconductor layer of a second conductivity type disposed on one surface of the semiconductor substrate of the first conductivity type;
a back side electrode disposed so as to be electrically connected to the other surface of the semiconductor substrate of the first conductivity type;
a passivation film disposed in contact with the surface of the semiconductor layer of the second conductivity type; and
a light incident side surface-electrode disposed on at least a portion of the surface of the passivation film,
wherein the light incident side surface-electrode is a light incident side surface-electrode that is processed to irradiate light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction, and
the conductive paste is a conductive paste for forming the light incident side surface.

12. A solar cell comprising:

a semiconductor substrate of a first conductivity type;
a semiconductor layer of a second conductivity type disposed on one surface of the semiconductor substrate of the first conductivity type;
a back side electrode disposed so as to be electrically connected to the other surface of the semiconductor substrate of the first conductivity type;
a passivation film disposed in contact with the surface of the semiconductor layer of the second conductivity type; and
a light incident side surface-electrode disposed on at least a portion of the surface of the passivation film,
wherein the light incident side surface-electrode is a light incident side surface-electrode that is processed to irradiate light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction, and
the light incident side surface-electrode is a fired body of the conductive paste according to any one of claims 1 to 10.

13. A solar cell comprising:

a crystalline silicon substrate of a first conductivity type;
a silicon emitter layer of a second conductivity type disposed on one surface of the semiconductor substrate of the first conductivity type;
a back side electrode disposed so as to be electrically connected to the other surface of the crystalline silicon substrate of the first conductivity type;
a passivation film disposed in contact with the surface of the silicon emitter layer of the second conductivity type; and
a light incident side surface-electrode comprising silver disposed on at least a portion of the surface of the passivation film,
wherein the silicon emitter layer of the second conductivity type has a local conductive portion in direct contact with the light incident side surface-electrode without a passivation film,
the local conductive portion comprises an alloy of silver and silicon, and
the light incident side surface-electrode is a fired body of the conductive paste according to any one of claims 1 to 10.

14. A method for producing a solar cell, comprising:

providing a semiconductor substrate of a first conductivity type;

forming a semiconductor layer of a second conductivity type on one surface of the semiconductor substrate of the first conductivity type;

forming a back side electrode so as to be electrically connected to the other surface of the semiconductor substrate of the first conductivity type;

forming a passivation film so as to be in contact with the surface of the semiconductor layer of the second conductivity type;

forming a light incident side surface-electrode on at least a portion of the surface of the passivation film; and

irradiating light from a point light source to the light incident side surface of the solar cell, while applying a voltage between the back side electrode and the light incident side surface-electrode such that an electric current flows between the semiconductor layer of the second conductivity type and the semiconductor substrate of the first conductivity type in a direction opposite to the forward bias direction,

wherein the light incident side surface-electrode is a fired body of the conductive paste according to any one of claims 1 to 10.

15. Use of the conductive paste according to any one of claim 1 to 11 for forming an electrode of a solar cell.

Fig. 1

20, 20b

2

4

1

16

15, 15b

Fig. 2

20

20b   20a

2

Fig. 3

Fig. 4

Fig. 5

20, 20b

2

4

1

16

15, 15b

Fig. 6

1mm

1mm

10mm

0.1mm

Fig. 7

Fig. 8

Fig. 9

Fig. 10

Fig. 11

Fig. 12

Fig. 13

## INTERNATIONAL SEARCH REPORT

| International application No. |
|---|
| **PCT/JP2023/012085** |

**A. CLASSIFICATION OF SUBJECT MATTER**

*H01L 31/0224*(2006.01)i; *H01B 1/22*(2006.01)i; *H01L 31/068*(2012.01)i; *H01L 31/18*(2006.01)i
FI:  H01L31/04 264; H01B1/22 A; H01L31/04 400; H01L31/06 300

According to International Patent Classification (IPC) or to both national classification and IPC

**B. FIELDS SEARCHED**

Minimum documentation searched (classification system followed by classification symbols)

H01L31/00-31/078; H01L31/18-31/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2014-150015 A (NAMICS CO.) 21 August 2014 (2014-08-21)<br>paragraphs [0013], [0060], [0066], [0071], [0079], [0080], [0083], [0086], [0090], [0092]-[0094], [0113], fig. 1 | 1-15 |
| Y | JP 2009-231826 A (MITSUBISHI MATERIALS CORP.) 08 October 2009 (2009-10-08)<br>paragraphs [0006], [0025], [0027], [0030], [0036], fig. 1 | 1-15 |
| Y | JP 2017-162636 A (NAMICS CO.) 14 September 2017 (2017-09-14)<br>paragraphs [0040], [0041], [0046], [0124], fig. 3 | 9-15 |
| Y | JP 2019-525471 A (AIC HOERMANN GMBH & CO. KG) 05 September 2019 (2019-09-05)<br>paragraphs [0030], [0032], fig. 5 | 11-15 |
| A | JP 2011-129884 A (MURATA MANUFACTURING CO., LTD.) 30 June 2011 (2011-06-30)<br>entire text, all drawings | 1-15 |
| A | JP 2007-273256 A (MURATA MANUFACTURING CO., LTD.) 18 October 2007 (2007-10-18)<br>entire text, all drawings | 1-15 |

☑ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 May 2023** | **06 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/012085**

**C.      DOCUMENTS CONSIDERED TO BE RELEVANT**

| Category* | Citation of document, with indication, where appropriate, of the relevant passages | Relevant to claim No. |
|---|---|---|
| A | WO 2013/046903 A1 (NORITAKE CO., LTD.) 04 April 2013 (2013-04-04)<br>entire text, all drawings | 1-15 |
| A | JP 2009-231827 A (MITSUBISHI MATERIALS CORP.) 08 October 2009 (2009-10-08)<br>entire text, all drawings | 1-15 |
| A | US 2016/0284892 A1 (LG ELECTRONICS INC.) 29 September 2016 (2016-09-29)<br>entire text, all drawings | 1-15 |
| A | MORINAGA, Kenji et al. Compositional Dependence of Absorption Spectra of Ti3+ in Silicate, Borate, and Phosphate Glasses. Journal of the American Ceramic Society, 1994, vol. 77, no. 12, pp. 3113-3118, DOI: 10.1111/j.1151-2916.1994.tb04557.x<br>particularly, table 3 | 1-15 |

Form PCT/ISA/210 (second sheet) (January 2015)

INTERNATIONAL SEARCH REPORT
Information on patent family members

International application No.

**PCT/JP2023/012085**

| Patent document cited in search report | | | Publication date (day/month/year) | Patent family member(s) | | Publication date (day/month/year) |
|---|---|---|---|---|---|---|
| JP | 2014-150015 | A | 21 August 2014 | (Family: none) | | |
| JP | 2009-231826 | A | 08 October 2009 | (Family: none) | | |
| JP | 2017-162636 | A | 14 September 2017 | US 2019/0044005 A1 paragraphs [0052], [0053], [0058], table 1, fig. 3 CN 108701504 A KR 10-2018-0116424 A | | |
| JP | 2019-525471 | A | 05 September 2019 | US 2021/0288208 A1 paragraphs [0032]-[0034], fig. 5 CN 109673171 A KR 10-2019-0035850 A | | |
| JP | 2011-129884 | A | 30 June 2011 | (Family: none) | | |
| JP | 2007-273256 | A | 18 October 2007 | (Family: none) | | |
| WO | 2013/046903 | A1 | 04 April 2013 | US 2014/0239238 A1 entire text, all drawings CN 103827052 A KR 10-2014-0090607 A | | |
| JP | 2009-231827 | A | 08 October 2009 | (Family: none) | | |
| US | 2016/0284892 | A1 | 29 September 2016 | KR 10-2015-0054352 A CN 104637567 A | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019525471 A
- JP 2021513218 A
- JP 2011086754 A
- JP 2009231826 A

**Non-patent literature cited in the description**

- **K. MORINAGA** ; **H. YOSHIDA** ; **H. TAKEBE**. *J. AmCerm. Soc*, 1994, vol. 77, 3113